(19) Europäisches Patentamt
European Patent Office
Office européen des brevets

(11) **EP 4 379 366 A1**

(12) **EUROPÄISCHE PATENTANMELDUNG**

(43) Veröffentlichungstag:
**05.06.2024 Patentblatt 2024/23**

(21) Anmeldenummer: **23213212.6**

(22) Anmeldetag: **30.11.2023**

(51) Internationale Patentklassifikation (IPC):
**G01N 27/414** (2006.01) **G01R 31/26** (2020.01)

(52) Gemeinsame Patentklassifikation (CPC):
**G01N 27/4148; G01N 27/414; G01R 31/26**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **02.12.2022 DE 102022131978**

(71) Anmelder:
• **Technische Universität Dresden Körperschaft des
öffentlichen Rechts
01069 Dresden (DE)**

• **Pg40 Consulting Group GmbH
04107 Leipzig (DE)**

(72) Erfinder:
• **WUTTKE, Thomas
04107 Leipzig (DE)**
• **WARTENBERG, Aaron
93047 Regensburg (DE)**
• **BURKHARDT, Wolfram
17489 Greifswald (DE)**
• **RICHTER, René
01737 Tharandt (DE)**

(74) Vertreter: **Viering, Jentschura & Partner mbB
Patent- und Rechtsanwälte
Am Brauhaus 8
01099 Dresden (DE)**

(54) **AKTIVE MESSSCHALTUNG UND VERFAHREN ZUM BETREIBEN EINER AKTIVEN MESSSCHALTUNG**

(57) Gemäß verschiedenen Ausführungsbeispielen weist die Anmeldung eine Aktive Messschaltung (100) auf:

eine elektrische Leistungsquelle (110), eine Brückenschaltung (200), wobei ein Brückeneingangsknoten (201) der Brückenschaltung (200) und ein Brückenausgangsknoten (202) der Brückenschaltung (200) mit der elektrischen Leistungsquelle (110) verbunden sind, wobei ein Feldeffekttransistor (211) und

ein erstes Widerstandsbauteil (212) einen ersten Brückenast (210) der Brückenschaltung (200) zwischen dem Brückeneingangsknoten (201) und dem Brückenausgangsknoten (202) bilden, wobei ein zweites Widerstandsbauteil (221) und ein drittes Widerstandsbauteil (222) einen zweiten Brückenast (220) der Brückenschaltung (200) zwischen dem Brückeneingangsknoten (201) und dem Brückenausgangsknoten (202) bilden, wobei ein Operationsverstärker (230) einen Brückenzweig zwischen dem ersten Brückenast (210) und dem zweiten Brückenast (220) der Brückenschaltung (200) bildet, und wobei der Operationsverstärker (230) mit einem Gate-Kontakt des Feldeffekttransistors (211) verbunden ist.

FIG. 2A

**Beschreibung**

Verschiedene Ausführungsformen betreffen eine aktive Messschaltung und Verfahren zum Betreiben einer aktiven Messschaltung.

Im Allgemeinen können sogenannte chemisch sensitive Feldeffekttransistoren (kurz ChemFET) und ionensensitive Feldeffekttransistoren (kurz ISFET) innerhalb von Sensor-Messschaltungen relevant sein. Beispielsweise kann der ChemFET bzw. ISFET als ein Sensorelement fungieren, um eine Stoffkonzentration eines Biomarkers, wie beispielsweise einen pH-Wert oder einen Blutzuckerspiegel, innerhalb einer zu untersuchenden Substanz zu ermitteln.

Somit können beispielsweise Biomarker (z.B. Stoffe, Vitalparameter etc.) von Patienten überwacht werden. Es kann vorteilhaft sein, derartige Messschaltungen für tragbare Geräte bereitzustellen, da diese dann eine selbstständige und kontinuierliche Überwachung der patientenspezifischen Biomarker ermöglichen können. Somit kann beispielsweise eine Selbstmedikation bei Krankheiten (z.B. Diabetes) vereinfacht oder überhaupt erst ermöglicht werden.

Eine grundlegende Herausforderung für eine derartige Messschaltung kann sein, ein Ausgangssignal zu erzeugen, das eine möglichst einfache Messauswertung ermöglicht. Rein prinzipiell können dazu zwei von drei elektrischen Messgrößen eines Feldeffekttransistors ermittelt werden: eine Drain-Source-Spannung, ein Drainstrom und eine Gate-Source-Spannung oder eine Referenzspannung. Derartige Messschaltung verwenden im Allgemeinen mehrere konstante Leistungsquellen (z.B. Stromquellen und/oder Spannungsquellen), was in höheren Kosten, einem größeren benötigten Bauraum und einem höheren Gesamtenergieverbrauch der Messschaltung resultieren kann, wodurch eine Anwendung in einem tragbaren Gerät behindert wird.

Für eine der oben genannten Anwendungen - in einem tragbaren Gerät - kann eine Messschaltung vorteilhaft sein, die in einem Niedrig-Leistungsbereich betrieben werden kann.

Um eine Messschaltung im Niedrig-Leistungsbereich zu realisieren, gibt es im Labormaßstab zwar verschiedene Möglichkeiten, jedoch mangelt es an Möglichkeiten, derartige Messschaltungen auch auf einem kleinen Bauraum unter den Anforderungen einer Niedrig-Leistungsanwendung zu realisieren (z.B. mit einem geringen Betriebsstrom, einer geringen Betriebsspannung, einer langen Betriebszeit).

Gemäß verschiedenen Aspekten wurde erkannt, wie eine Messschaltung auf kleinem Bauraum und mit sehr geringem Energieverbrauch umgesetzt werden kann. Ferner wurde erkannt, dass ein organischer elektrochemischer Transistor und/oder ein chemisch sensitiver Feldeffekttransistor (kurz ChemFET) und/oder ein ionensensitiver Feldeffekttransistor (kurz ISFET) einen geringen Energieverbrauch haben, und daher auch mit geringen Leistungen arbeiten können.

Gemäß verschiedenen Aspekten wird eine Messschaltung bereitgestellt, die organischen elektrochemischen Transistor und/oder einen chemisch sensitiven Feldeffekttransistor (ChemFET) und/oder einen ionensensitiven Feldeffekttransistor (ISFET) aufweisen kann.

Gemäß verschiedenen Aspekten wird eine Messschaltung bereitgestellt, die aufgrund ihres geringen Energieverbrauchs in sogenannten Niedrig-Leistungsanwendungen, wie beispielsweise in tragbaren Geräten wie z.B. Smart Watches etc., verwendet werden kann.

Gemäß verschiedenen Aspekten wird eine Messschaltung bereitgestellt, die eingerichtet ist, eine Spannung zu erfassen, die von einer zu ermittelnden Stoffkonzentration (z.B. von einem Biomarker) abhängig ist. Beispielsweise kann die zu erfassende Spannung linear von der zu ermittelnden Stoffkonzentration abhängig sein. Beispielsweise kann die Messschaltung direkt an einen geeigneten Mikrocontroller angeschlossen werden, z.B. angeschlossen sein, oder den Mikrocontroller aufweisen.

Gemäß verschiedenen Aspekten wird eine Messschaltung bereitgestellt, die eingerichtet ist, einen Analog-Digital-Wandler direkt mittels der Messschaltung in einer Niedrig-Leistungsanwendung zu betreiben.

Gemäß verschiedenen Aspekten wird eine Brückenschaltung bereitgestellt, die eingerichtet ist, um Signal-Schwankungen auszugleichen und eine Fehlerkorrektur durchzuführen. Die Brückenschaltung besteht aus zwei Brückenästen und einem Brückenzweig.

Gemäß verschiedenen Aspekten wird eine Messschaltung bereitgestellt, die aus einer geringstmöglichen Anzahl von elektronischen Bauteilen besteht, um somit eine Niedrig-Leistungs-Anwendung (auch als Low-Power-Anwendung bezeichnet) zu ermöglichen. Beispielsweise kann eine derartige Messschaltung einen Transistor (z.B. einen organischen elektrochemischen Transistor), beispielsweise einen Feldeffekttransistor (FET) (z.B. einen ISFET oder ChemFET), mindestens (z.B. genau) drei elektrische Widerstandsbauteile, einen Operationsverstärker und eine Leistungsquelle aufweisen (z.B. daraus bestehen). Gemäß verschiedenen Aspekten, kann die Messschaltung optional ferner einen Kondensator und/oder ein zusätzliches elektrisches Widerstandsbauteil aufweisen.

Gemäß verschiedenen Aspekten wird eine aktive Messschaltung bereitgestellt, die aufweist: eine elektrische Leistungsquelle, eine Brückenschaltung, wobei ein Brückeneingangsknoten der Brückenschaltung und ein Brückenausgangsknoten der Brückenschaltung mit der elektrischen Leistungsquelle verbunden sind, wobei ein Transistor, beispielsweise ein Feldeffekttransistor und ein erstes Widerstandsbauteil einen ersten Brückenast der Brückenschaltung zwischen dem Brückeneingangsknoten und dem Brückenausgangsknoten bilden, wobei ein zweites Widerstandsbauteil und ein drittes Widerstandsbauteil einen zweiten Brückenast der Brückenschaltung zwischen dem Brückeneingangsknoten und dem Brückenausgangsknoten bilden, wobei ein Operationsverstärker einen Brückenzweig zwischen dem ersten Brückenast und dem zweiten Brückenast der Brückenschaltung bildet, und wobei der Operationsverstärker mit einem Gate-Kontakt des Transistors, beispielsweise des Feldeffekttransistors, verbunden ist.

Gemäß verschiedenen Aspekten wird ein Verfahren zum Betreiben einer hierin beschriebenen aktiven Messschaltung bereitgestellt, wobei das Verfahren aufweist: In-Kontakt bringen eines zu Untersuchenden Mediums mit dem Transistor, beispielsweise dem Feldeffekttransistor der aktiven Messschaltung; Erfassen eines ersten Messsignals, das eine Brücken-Spannung zwischen dem Brückeneingangsknoten und dem Brückenausgangsknoten repräsentiert, und/oder Erfassen eines zweiten Messsignals, das eine Gate-Spannung des Transistors, beispielsweise des Feldeffekttransistors, repräsentiert; Ermitteln eines Werts einer Ausgangsspannung basierend auf dem ersten Messsignal und dem zweiten Messsignal; und Ermitteln eines Biomarkermesswerts, der zu der Ausgangsspannung korrespondiert.

Ausführungsformen sind in den Figuren dargestellt und werden im Folgenden näher erläutert.

Fig.1A zeigt einen ionenselektiven Feldeffekttransistor 211-i gemäß verschiedenen Aspekten.
Fig.1B zeigt einen Ausschnitt 10 einer Messschaltung gemäß verschiedenen Aspekten.
Figuren 2A und 2B zeigen eine Messschaltung gemäß verschiedenen Aspekten.
Figuren 2C und 2D zeigen eine ermittelte Ausgangsspannung gemäß verschiedenen Aspekten.
Figuren 3 bis 6 zeigen eine Messschaltung gemäß verschiedenen Aspekten.
Fig.7 eine schematische ein Verfahren zum Betreiben einer hierin beschriebenen aktiven Messschaltung gemäß verschiedenen Aspekten.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende Beschreibung ist deshalb nicht in einschränkendem Sinne aufzufassen, und der Schutzumfang der vorliegenden Erfindung wird durch die angefügten Ansprüche definiert.

Hierin wird unter "gekoppelten" elektrischen Bauteilen verstanden, dass mindestens zwei elektrische Bauteile eine ohmsche, induktive und/oder kapazitive elektrische Verbindung miteinander haben.

Werden hierin elektronische Bauteile als miteinander "verbunden" oder als "elektrisch verbunden" beschrieben, wird darunter verstanden, dass diese Bauteile mittels einer elektrisch leitfähigen Verbindung (z.B. einem elektrischen Leiter, z.B. einem Draht, einem Kabel) miteinander verbunden sind. Anschaulich sind die elektronischen Bauteile ohmsch miteinander verbunden, z.B. galvanisch miteinander gekoppelt.

Gemäß verschiedenen Aspekten kann eine elektrische Schaltung hierin einen "Knotenpunkt", der auch kurz als "Knoten" bezeichnet werden kann, aufweisen. Unter einem Knotenpunkt/Knoten wird hierin ein Abschnitt der elektrischen Schaltung verstanden, in dem mehrere Leitungen oder Anschlüsse mehrerer elektrischer Bauteile elektrisch leitfähig direkt miteinander verbunden sind. Es versteht sich, dass ein Knoten somit nicht unbedingt durch ein reales elektrisches Bauteil realisiert sein muss. Beispielsweise kann ein Knoten in einer realen Schaltung lediglich eine Abzweigung sein, durch die ein Strom geteilt wird. Es versteht sich ferner, dass die Summe der in einen Knoten eingehenden Stromstärken, gleich der Summe der aus dem Knoten ausgehenden Stromstärken ist (Knotenregel). Ferner versteht es sich, dass alle elektrischen Leitungen, die direkt mit dem Knoten verbunden sind, d.h. ohne zusätzliche dazwischengeschaltete Bauteile, auf dem gleichen elektrischen Potential wie der Knoten sind. Beispielsweise kann ein Knoten auch ein virtueller Punkt innerhalb der Schaltung sein, der verwendet wird, um elektrische Potentiale an verschiedenen elektrischen Bauteilen miteinander in Relation zu setzen.

Unter einem Mikrocontroller kann hierin ein Halbleiterchip verstanden werden, der dazu eingerichtet ist, ein oder mehrere Funktionen durchzuführen. Beispielsweise kann der Mikrocontroller einen Prozessor aufweisen, der eingerichtet sein kann, um Berechnungen, Logikoperationen etc. durchzuführen. Beispielsweise kann der Mikrocontroller ein oder mehrere andere elektronische Bauteile aufweisen, die jeweils zum Durchführen ein oder mehrerer Funktionen eingerichtet sind, wie beispielsweise einen Signalwandler, der eingerichtet ist zum Umwandeln eines Signals eines ersten Typs in ein Signal eines zweiten Typs, eine Schnittstelleneinheit, die eingerichtet ist zum Übermitteln und/oder zum Empfangen von Signalen von einer Vorrichtung außerhalb des Mikrocontrollers (z.B. CAN- (Controller Area Network), LIN-(Local Interconnect Network), USB- (Universal Serial Bus), $I^2C$- (Inter-Integrated Circuit), SPI- (Serial Peripheral Interface), serielle oder Ethernet-Schnittstellen), etc. Beispielsweise kann ein Mikrocontroller als ein Ein-Chip-Computersystem (z.B. ein System-on-a-Chip (SoC)) ausgestaltet sein.

Unter einem elektrischen Widerstandsbauteil wird hierin ein elektrisches Bauteil verstanden, das einen ohmschen Widerstand in einer elektrischen Schaltung (z.B. einer Messschaltung) realisiert. Ein elektrisches Widerstandsbauteil ist ein zweipoliges passives elektrisches Bauelement. Unter einem elektrischen Widerstandsbauteil werden hierin keine Bauteile verstanden, die verwendet werden um elektrisch leitfähige Verbindungen zwischen elektrischen Bauteilen zu realisieren, beispielsweise Kabel, Drähte etc. Es versteht sich, dass ein Widerstandsbauteil mittels mehrerer direkt hintereinander geschalteter Widerstandsbauteile (anschaulich direkt in Reihe geschalteter Widerstandsbauteile) realisiert werden kann.

Gemäß verschiedenen Aspekten weist die Messschaltung einen Feldeffekttransistor auf, mittels dem eine Stoffkonzentration ermittelt werden kann. Nachfolgend soll kurz das Funktionsprinzip eines ionenselektiven Feldeffekttransistors ISFET) beschrieben werden. Es versteht sich, dass ein chemisch sensitiver Feldeffekttransistor (ChemFET) in analoger Weise funktioniert.

Auch wenn die folgenden Beispiele verschiedene Aspekte dieser Offenbarung unter Verwendung eines ionenselektiven Feldeffekttransistors ISFET) beschrieben werden, so ist darauf hinzuweisen, dass diese Beispiele in analoger Weise ebenso für einen organischen elektrochemischen Transistor (OECT) oder auch für einen chemisch sensitiven Feldeffekttransistor (ChemFET) gelten und implementiert werden können.

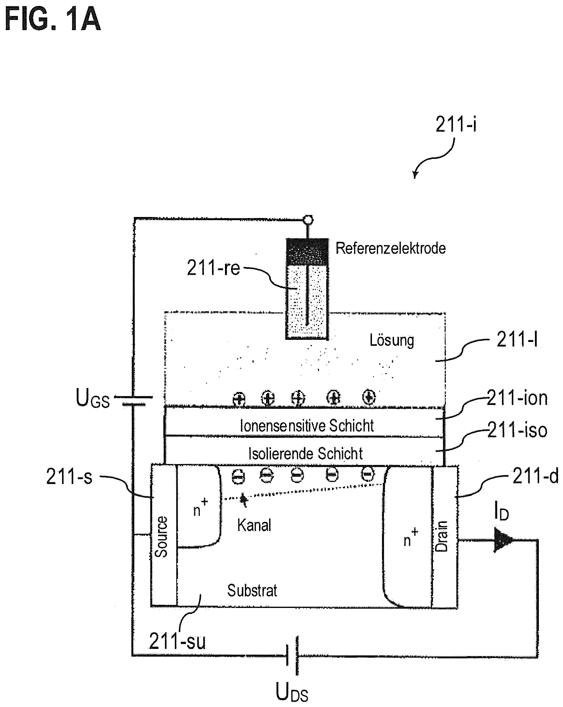

**FIG.1A** zeigt beispielshaft einen ionenselektiven Feldeffekttransistor 211-i gemäß verschiedenen Aspekten. Der ionenselektive Feldeffekttransistor 211i kann eine Referenzelektrode 211-re, einen Source-Kontakt 211-s und einen Drain-Kontakt 211-d aufweisen, die eingerichtet sind, um den ionenselektiven Feldeffekttransistor 211-i elektrisch zu kontaktieren. Der Source-Kontakt 211-s und der Drain-Kontakt 211-d können mit einem Substrat 211-su, z.B. einem (z.B. dotierten) Halbleitersubstrat, verbunden sein. Zwischen dem Source-Kontakt 211-s und dem Drain-Kontakt 211-d kann ein Gate-Bereich innerhalb des Substrats 211-su ausgebildet sein. Über dem Gatebereich kann ein Schichtstapel ausgebildet sein, der eine ionensensitive Schicht 211-ion und eine elektrisch isolierende Schicht 211-iso aufweist, wobei die elektrisch isolierende Schicht 211-iso die ionensensitive Schicht 211-ion elektrisch von dem Substrat 211-su isoliert. Zwischen der ionensensitive Schicht 211-ion und der Referenzelektrode 211-re kann sich ein Lösungsmittelbereich 211-l befinden, in den eine Lösung eingebracht werden kann, die eine zu ermittelnde Konzentration eines vorbestimmten Stoffes aufweist. Anschaulich fungieren die Referenzelektrode 211-re, der Lösungsmittelbereich 211-l und die ionensensitive Schicht 211-ion als eine Gate-Elektrode des ionenselektiven Feldeffekttransistor 211-i.

Die ionensensitive Schicht 211-ion kann dazu eingerichtet sein, dass sich die Ionen des vorbestimmten Stoffes an dieser anlagern können. Infolge der Anlagerung der Ionen des vorbestimmten Stoffes kann sich eine elektrische Eigenschaft der ionensensitiven Schicht 211-ion verändern und somit kann sich eine Gate-Eigenschaft des ionenselektiven Feldeffekttransistor 211-i ändern, wodurch eine Ermittlung der Konzentration ermöglicht wird.

An dem ionenselektiven Feldeffekttransistor 211-i können verschiedene Messgrößen gemessen werden, mittels derer die elektrischen Eigenschaften des ionenselektiven Feldeffekttransistors 211-i ermittelt werden können. Beispielsweise kann zwischen der Referenzelektrode 211-re und dem Source-Kontakt 211-s eine Gate-Source-Spannung $U_{GS}$ gemessen werden. Beispielsweise kann zwischen dem Source-Kontakt 211-s und dem Drain-Kontakt 211-d eine Drain-Source-Spannung $U_{DS}$ gemessen werden. Beispielsweise kann am Drain-Kontakt 211-d ein Drainstrom $I_D$ gemessen werden, der hierin auch als ein Source-Drain-Strom $I_{SD}$ bezeichnet werden kann. In der Fig.1A ist der Drainstrom $I_D$ beispielhaft in physikalischer Stromrichtung dargestellt. Ferner weist der Feldeffekttransistor 211-i zwischen dem Source-Kontakt 211-s und dem Drain-Kontakt 211-d einen Drain-Source-Widerstand $R_{DS}$ auf. Beispielsweise kann der Drain-Source-Widerstand $R_{DS}$ konstant sein (z.B. bleiben), wenn der Drainstrom $I_D$ und die Drain-Source-Spannung $U_{DS}$ konstant sind (z.B. bleiben).

Wird nun eine Lösung, welche die zu ermittelnde Konzentration aufweist, in den Lösungsmittelbereich 211-l eingebracht, können sich die Ionen des vorbestimmten Stoffes an der ionensensitiven Schicht 211-ion anlagern, wodurch sich die elektrischen Eigenschaften des Gates und somit des ionenselektiven Feldeffekttransistors 211-i ändern können. Diese Veränderung kann beispielsweise basierend auf einer Veränderung des Drainstrom $I_D$, der Gate-Source-Spannung $U_{GS}$, und/oder der Drain-Source-Spannung $U_{DS}$ erkannt und ermittelt werden. Da die Veränderung abhängig von der zu ermittelnden Konzentration ist, kann somit, basierend auf der gemessenen Veränderung der elektrischen Eigenschaften des ionenselektiven Feldeffekttransistors 211-i, auch die zu ermittelnde Konzentration ermittelt werden.

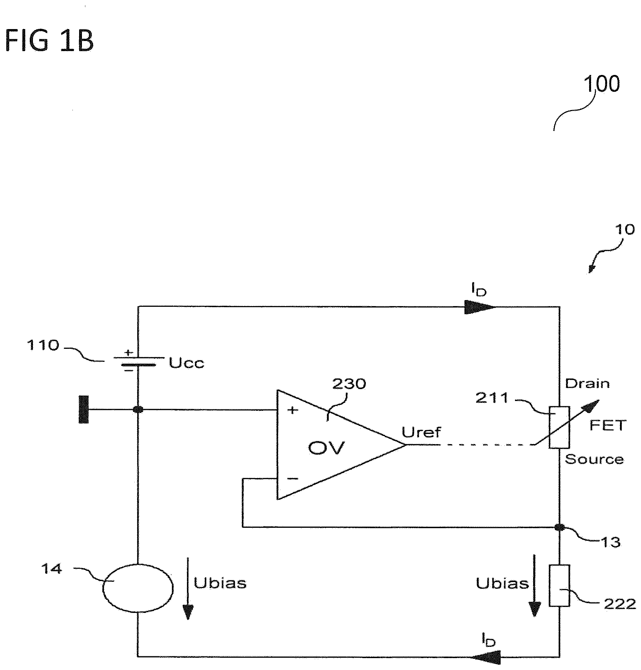

**Fig.1B** stellt einen Ausschnitt 10 einer Messschaltung gemäß verschiedenen Aspekten dar. Die Messschaltung weist auf ein regelbares elektrisches Widerstandsbauteil 14, einen Feldeffekttransistor (z.B. einen ISFET oder einen ChemFET) 211 (nachfolgend auch lediglich als FET bezeichnet), ein erstes elektrisches Widerstandsbauteil 222 und einen Operationsverstärker 230. Der Drain-Kontakt des FET 211 ist mit dem regelbaren elektrischen Widerstandsbauteil 14 verbunden und der Source-Kontakt des FET 211 ist mit einem ersten Knoten 13 verbunden. Der erste Knoten 13 ist ferner mit dem ersten elektrischen Widerstandsbauteil 222 und einem Eingang des Operationsverstärkers 230 verbunden. Der Gate-Kontakt des FET 211 (z.B. die Referenzelektrode aus FIG.1A) ist mit dem Ausgang des Operationsverstärkers 230 verbunden, dargestellt mittels einer gestrichelten Linie.

Die dargestellte Messschaltung weist lediglich eine elektrische Eingangsgröße auf - eine Leistungsversorgungsspannung Ucc. Mittels des regelbaren elektrischen Widerstandsbauteils 14 kann eine Spannung $U_{Bias}$ verändert und eingestellt werden. An einem Ausgang des Operationsverstärkers 230 kann eine Ausgangsspannung $U_{Ref}$ anliegen und somit ermittelt (z.B. gemessen) werden. Die Ausgangsspannung $U_{Ref}$ kann hierin auch als eine Referenzspannung oder als eine Spannung, die an der Referenzelektrode des Feldeffekttransistors 211 anliegt, bezeichnet werden. Beispielsweise kann die Ausgangsspannung $U_{Ref}$ mittels eines Analog-Digital-Wandlers ermittelt werden, wie später beschrieben wird.

Aufgrund der Topologie der Schaltung kann eine gemessene Ausgangsspannung $U_{Ref*}$ um eine Offsetspannung $U_{ofs}$ (nicht dargestellt) erhöht sein. Die Offsetspannung $U_{ofs}$ kann ebenfalls ermittelt werden. Dies ermöglicht es, die gemessene Ausgangsspannung $U_{ref*}$ von der Offsetspannung $U_{ofs}$ zu bereinigen, um somit die reale Ausgangsspannung $U_{ref}$ zu erhalten.

Gemäß verschiedenen Aspekten wurde erkannt, dass die Messschaltung einen linearen Zusammenhang zwischen einer zu ermittelnden Ionenkonzentration und der Ausgangsspannung $U_{ref}$ bereitstellen kann, wenn ein Drain-Source-Widerstand $R_{DS}$ des Feldeffekttransistors 211 konstant ist - unabhängig von der Ausgangsspannung $U_{ref}$. In einer derartigen Konfiguration kann die Ausgangsspannung $U_{ref}$ linear die Ionenkonzentration abbilden (z.B. in einem linearen Zusammenhang mit der Ionenkonzentration sein).

Gemäß verschiedenen Aspekten wurde ferner erkannt, dass der Operationsverstärker 230 verwendet werden kann, um das beschriebene lineare Abbilden zu ermöglichen. Anschaulich stellt der Operationsverstärker 230 die Ausgangsspannung $U_{ref}$ immer so ein, dass ein Arbeitspunkt des FET 211 gleich bleibt. Der Arbeitspunkt des FET 211 kann hierbei mittels der Drain-Source-Spannung $U_{DS}$ und des Drainstroms $I_D$ definiert werden, welche, aufgrund des Operationsverstärkers 230, konstant bleiben. Außerdem, da der Drain-Source-Widerstand $R_{DS}$ der Quotient aus Drain-Source-Spannung $U_{DS}$ und Drainstrom $I_D$ ist, welche konstant bleiben, ist auch der Drain-Source-Widerstand $R_{DS}$ konstant.

Gemäß verschiedenen Aspekten können für das Bereitstellen des Arbeitspunkts des FET 211 verschiedene Leistungsquellen verwendet werden. Beispielsweise kann eine derartige Leistungsquelle eine Spannungsquelle sein, die eingerichtet sein kann, um über einen vorbestimmten Zeitraum (z.B. länger als 24 Stunden, z.B. länger als 7 Tage, z.B. länger als 1 Monat, z.B. länger als 6 Monate, z.B. länger als 1 Jahr) eine konstante Spannung bereitzustellen. Eine konstante Spannung bezeichnet hierbei eine elektrische Spannung, die um weniger als 10% (z.B. weniger als 5%, z.B. weniger als 2%, z.B. weniger als 1%) innerhalb des Zeitraums variiert. Beispielsweise kann eine derartige Leistungsquelle eine Stromquelle sein, welche dazu eingerichtet ist, den benötigte(n) konstante(n) Strom über den vorbestimmten Zeitraum mittels eines Spannungsabfalls an einem bekannten elektrischen Widerstandsbauteil und an einem Spannungsfolger bereitzustellen. Beispielsweise kann die Leistungsquelle mittels eines Mischbetriebs von einer Spannungsquelle und einer Stromquelle realisiert werden oder sein.

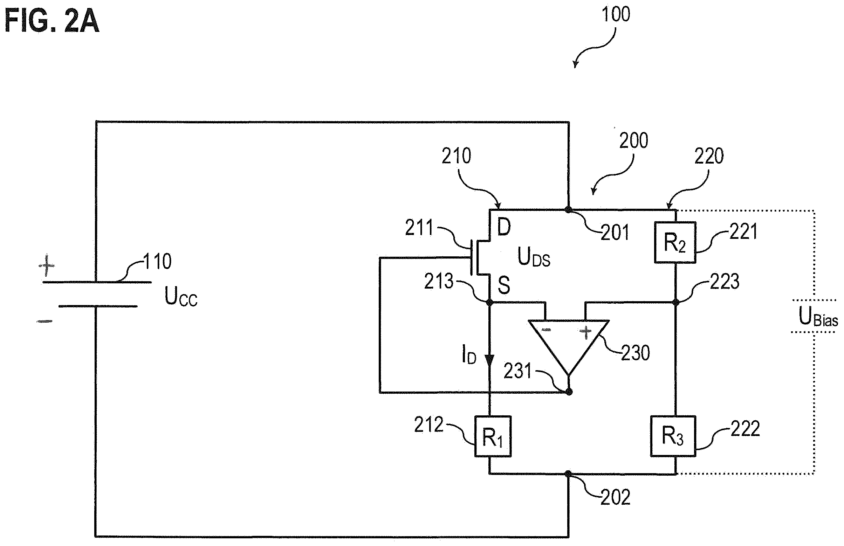

FIG.2A veranschaulicht eine Messschaltung 100 gemäß verschiedenen Aspekten. Die Messschaltung 100 kann eine Leistungsquelle 110 und eine Brückenschaltung 200 aufweisen. Die Leistungsquelle 110 kann mittels eines Brückeneingangsknotens 201 und eines Brückenausgangsknotens 202 mit der Brückenschaltung verbunden sein. Zwischen dem Brückeneingangsknoten 201 und dem Brückenausgangsknoten 202 kann eine Brückenspannung $U_{Bias}$ anliegen (dargestellt mittels der gepunkteten Linie), die hierin auch als Bias-Spannung bezeichnet werden kann. Sofern die Brückenschaltung 200 direkt mit der Leistungsquelle 110 verbunden ist, kann die Brückenspannung $U_{Bias}$ gleich zu einer Leistungsversorgungsspannung Ucc sein. Wie bereits zuvor beschrieben, bezeichnet dabei "elektrisch verbunden" oder kurz "verbunden", dass die zwei elektrischen Bauteile mittels einer elektrisch leitfähigen, d.h. ohmschen, Verbindung miteinander verbunden sind.

Gemäß verschiedenen Aspekten kann die Brückenschaltung einen ersten Brückenast 210 und einen zweiten Brückenast 220 aufweisen, die jeweils mittels des Brückeneingangsknotens 201 und des Brückenausgangsknotens 202 miteinander verbunden sind. Anschaulich können die beiden Brückenäste als ein Stromteiler verstanden werden, aufgrund dessen ein elektrischer Strom, der aus der Leistungsquelle 110 in den Brückeneingangsknoten 201 fließt, auf die beiden Brückenäste aufgeteilt werden kann. Der jeweilige Strom der Brückenäste kann basierend auf dem jeweiligen elektrischen Gesamt-Widerstand des Brückenasts ermittelt werden.

Gemäß verschiedenen Aspekten kann der erste Brückenast 210 analog zur Schaltung 10 aus FIG.1B ausgestaltet sein, d.h. der erste Brückenast kann einen FET 211 und ein elektrisches Widerstandsbauteil 212 aufweisen, die über einen ersten Brückenknoten 213 miteinander verbunden sind.

Der erste Brückenknoten 213 kann ferner mit einem ersten Eingang eines Operationsverstärkers 230 verbunden sein. Ein Gate-Kontakt des FET 211 (d.h. eine Referenzelektrode des FET) kann mit einem Ausgang des Operationsverstärkers 230 verbunden sein. Beispielsweise kann der Ausgang des Operationsverstärkers 230 mit einem Ausgabeknoten 231 verbunden sein, und der Gate-Kontakt des FET 211 kann ebenfalls mit dem Ausgabeknoten 231 verbunden sein, so dass beide, der Ausgang des Operationsverstärkers 230 und der Gate-Kontakt des FET 211, auf dem gleichen elektrischen Potential sind.

Gemäß verschiedenen Aspekten kann der zweite Brückenast 220 ein zweites elektrisches Widerstandsbauteil 221 und ein drittes elektrisches Widerstandsbauteil 222 aufweisen, die mittels eines zweiten Brückenknotens 223 miteinander verbunden sind. Der zweite Brückenknoten 223 kann mit einem zweiten Eingang des Operationsverstärkers 230 verbunden sein.

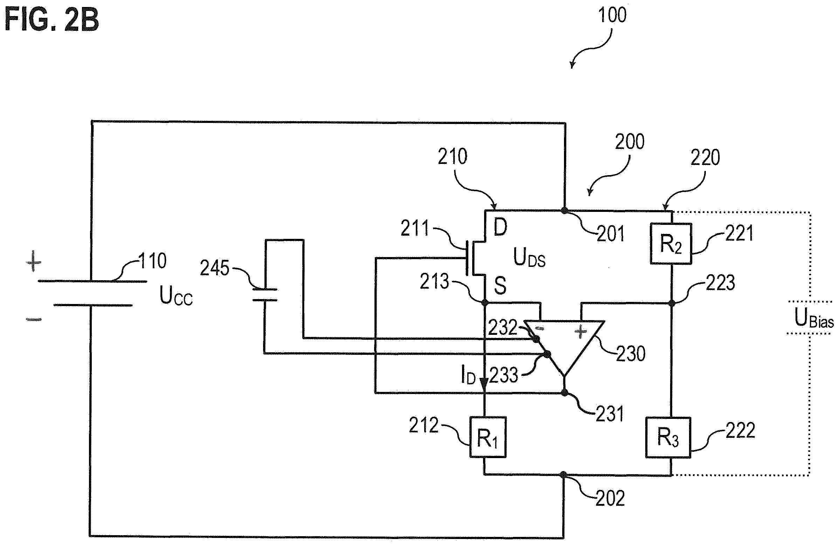

Der Operationsverstärker 230 kann beispielsweise mittels einer Operationsverstärker-Leistungsquelle 245 mit Leistung versorgt werden, wie in **FIG.2B** dargestellt ist. Beispielsweise kann die Operationsverstärker-Leistungsquelle 245 mit einem Mikrocontroller gekoppelt (z.B. verbunden) sein. Beispielsweise kann die Operationsverstärker-Leistungsquelle 245 in dem Mikrocontroller implementiert sein (z.B. mittels des Mikrocontrollers realisiert sein). Zur Übersichtlichkeit der Darstellung wird die separate Leistungsversorgung des Operationsverstärkers 230 in den anderen Figuren nicht mit dargestellt.

Somit bilden die elektrischen Bauteile des ersten Brückenasts 210 und des zweiten Brückenasts 220 jeweils einen Spannungsteiler innerhalb ihres jeweiligen Brückenasts.

Gemäß verschiedenen Aspekten wurde erkannt, dass die Brückenschaltung derart verwendet werden kann, dass sowohl der Drainstrom $I_D$ als auch die Drain-Source-Spannung $U_{DS}$ (zwischen dem Drain-Kontakt D und dem Source-Kontakt S des FET 211) aus einer einzigen vorgegebenen Leistungsquelle 110 bezogen werden können. Dabei können sowohl der Drainstrom $I_D$ als auch die Drain-Source-Spannung $U_{DS}$ direkt von der Leistungsquelle 110 und somit auch direkt linear von der an der Brückenschaltung 200 anliegenden Brücken-Spannung $U_{Bias}$ abhängig sein:

$$U_{DS} \propto U_{Bias} \qquad (1)$$

$$I_D \propto U_{Bias} \qquad (2)$$

Die Werte für den Drainstrom $I_D$ und die Drain-Source-Spannung $U_{DS}$ können mittels der ohmschen Widerstände der elektrischen Widerstandsbauelemente eingestellt werden:

$$U_{DS} = U_{Bias} \frac{R_2}{R_2 + R_3} \qquad (3)$$

$$I_D = U_{Bias} \frac{R_3}{R_1(R_2 + R_3)} \qquad (4)$$

Anschaulich bedeutet das, dass der Drain-Source-Widerstand $R_{DS}$ sich ausschließlich aus dem Verhältnis von drei ohmschen Widerständen ergibt, und nicht mehr von dem jeweiligen Drainstrom $I_D$ und/oder der Drain-Source-Spannung $U_{DS}$ abhängt:

$$R_{DS} = \frac{U_{SD}}{I_D} = \frac{R_1 R_2}{R_3} = const \qquad (5)$$

Somit ist es, um einen konstanten Drain-Source-Widerstand $R_{DS}$ in der Messschaltung 100 gemäß verschiedenen Aspekten bereitzustellen, weder notwendig eine konstante Spannung noch einen konstanten Strom mittels der Leistungsquelle 110 bereitzustellen.

Es versteht sich jedoch, dass bei einer realen Messschaltung eine Höhe der realen Werte der Drain-Source-Spannung $U_{DS}$ und des Drainstroms $I_D$, auch wenn deren Quotient konstant ist, trotzdem einen Einfluss auf die zu messende Ausgangsspannung $U_{Ref}$ haben können.

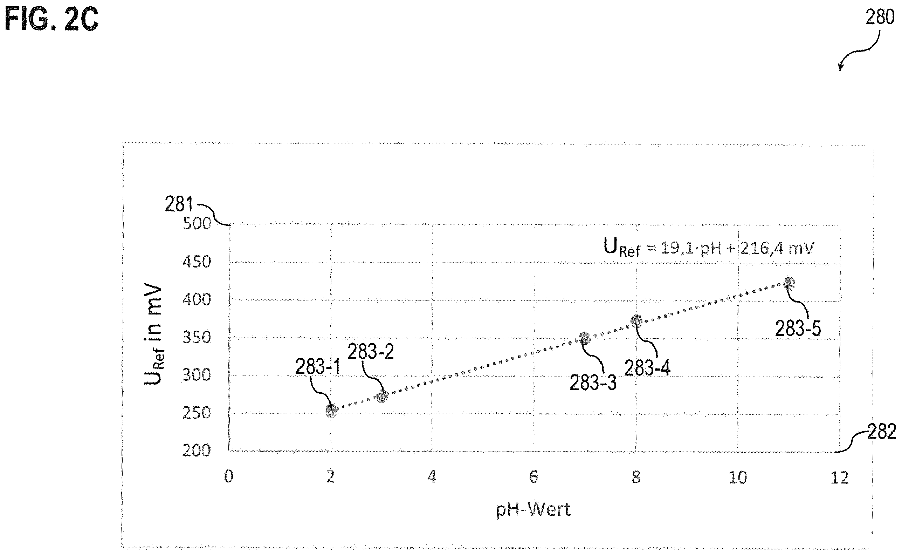

Gemäß verschiedenen Aspekten wurde erkannt, dass der Einfluss eines pH-Werts auf die zu messende Ausgangsspannung $U_{Ref}$ linear ist. Dies ist beispielhaft in Fig.2C dargestellt.

**Fig.2C** zeigt ein Diagramm 280, in dem auf der horizontalen Achse 282 ein pH-Wert dargestellt ist und auf der vertikalen Achse 281 eine experimentell ermittelte Ausgangsspannung $U_{Ref,exp}$ dargestellt ist. Die Messpunkte 283-1 bis 283-5 liegen auf einer Geraden, die mittels des folgenden Zusammenhangs dargestellt werden kann, wobei x den pH-Wert repräsentiert:

$$U_{Ref,exp}(x) = 19{,}1 \frac{mV}{pH} \cdot x + 216{,}4 \, mV \qquad (6)$$

Ferner wurde erkannt, dass die zu messende Ausgangsspannung $U_{Ref}$ nicht von den elektrischen Eigenschaften des konkret verwendeten FET 211 abhängt, wie beispielsweise einer Steilheit des FET, einem Gate-Schwellenwert des FET, etc.

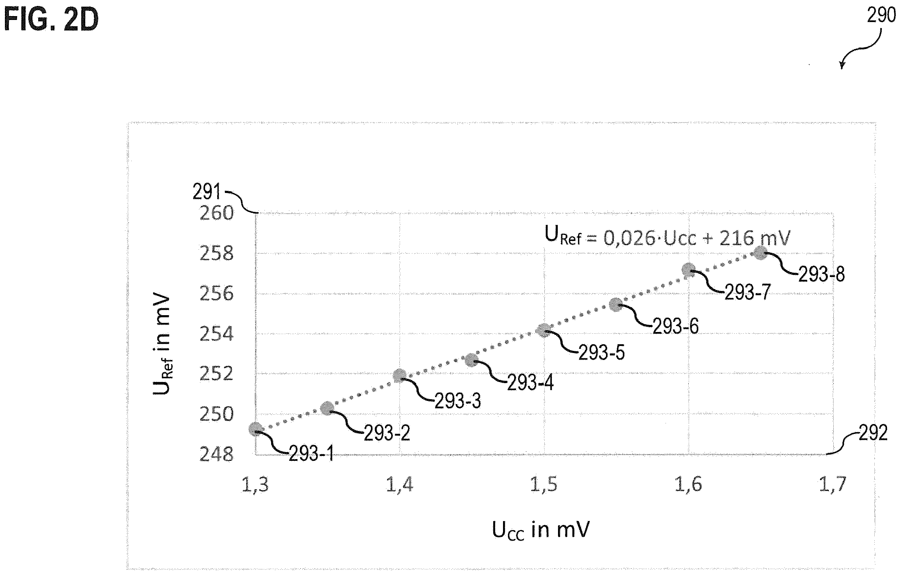

**FIG.2D** stellt beispielhaft ein Diagramm 290 dar, in dem auf der horizontalen Achse 292 eine Leistungsversorgungsspannung Ucc und auf der vertikalen Achse 291 eine experimentell ermittelte Ausgangsspannung $U_{Ref,exp}$ dargestellt sind. Die Punkte 293-1 bis 293-8 repräsentieren die ermittelten Spannungswerte der experimentell ermittelten Ausgangsspannung $U_{Ref,exp}$ für verschiedene Leistungsversorgungsspannung Ucc, die jeweils für einen konstanten pH-Wert von pH = 2 ermittelt wurden. Die Punkte 293-1 bis 293-8 liegen auf einer Geraden, die mittels des folgenden Zusammenhangs dargestellt werden kann, wobei y die Leistungsversorgungsspannung Ucc repräsentiert:

$$U_{Ref,exp}\,(y) = \,0{,}026 \cdot y + \,216\,\text{mV}$$

Anhand des Zusammenhangs ist zu erkennen, dass Schwankungen der Leistungsversorgungsspannung Ucc einen geringen Einfluss auf die experimentell ermittelte Ausgangsspannung $U_{REF}$ haben.

Beispielsweise kann der Einfluss von Schwankungen der Leistungsversorgungsspannung Ucc auf die Ausgangsspannung $U_{REF}$ ermittelt und anschließend korrigiert werden. Beispielsweise kann eine Initial-Versorgungsspannung $U_{CC\text{-}ini}$ die Leistungsversorgungsspannung Ucc repräsentieren, bei der die Kalibrierung des FET 211 durchgeführt wurde. Beispielsweise kann eine Leistungsversorgungsspannung $U_{CC\text{-}exp}$ experimentell ermittelt werden, die zu der experimentell ermittelten Ausgangsspannung $U_{Ref,exp}$ korrespondiert.

Die Spannungsdifferenz $\Delta U_{CC}$ aus der Initial-Versorgungsspannung $U_{CC\text{-}ini}$ und der experimentell ermittelten Leistungsversorgungsspannung $U_{CC\text{-}exp}$ kann mit einem Dämpfungsfaktor D versehen werden und von der experimentell ermittelten Ausgangsspannung $U_{Ref,exp}$ abgezogen werden. Der Dämpfungswert D ist unabhängig von einem pH-Wert.

$$U_{Ref} = U_{Ref,exp} - \,\Delta U_{CC} \cdot D = U_{Ref,exp} - (U_{CC-exp} - U_{CC-ini})\frac{R_3}{2 \cdot (R_3 + R_2)} \qquad (7)$$

Die Abhängigkeit der Ausgangsspannung $U_{REF}$ von der (z.B. abnehmenden) Leistungsversorgungsspannung Ucc kann während eines Batteriebetriebs eine kritische Größe darstellen.

Beispielsweise ermöglicht die beschriebene Korrektur eine Kalibrierung auf verschiedene Batterieladezustände.

Ferner können auch noch weitere Parameter einen Einfluss auf die Ausgangsspannung $U_{REF}$ haben, wie beispielsweise eine Temperatur und/oder Alterungsprozesse der Schaltung.

Gemäß verschiedenen Aspekten wurde ferner erkannt, dass der Einfluss der Brückenspannung $U_{Bias}$ bei einer Ermittlung der Ausgangsspannung $U_{Ref}$ mit verwendet werden kann. Dies ermöglicht beispielsweise, dass die Brückenspannung $U_{Bias}$ nicht zeitlich konstant über einen Zeitraum (z.B. von mehr als einem Tag, mehr als einer Woche, mehr als einem Monat, mehr als einem Jahr) sein muss. Anschaulich muss die Leistungsquelle nicht dazu eingerichtet sein, eine langzeitstabile Brückenspannung $U_{Bias}$ bereitzustellen.

Gemäß verschiedenen Aspekten kann die Messschaltung 100 optional ferner einen Vorwiderstand aufweisen, mittels dem die Brückenspannung $U_{Bias}$ ermittelt werden kann. Somit kann beispielsweise auf eine Referenzleistungsquelle (z.B. eine Referenzstromquelle oder Referenzspannungsquelle) verzichtet werden, wodurch Herstellungskosten der Messschaltung und/oder ein Energieverbrauch der Messschaltung reduziert werden können. Beispielsweise kann somit eine herkömmliche Batterie als Leistungsquelle verwendet werden.

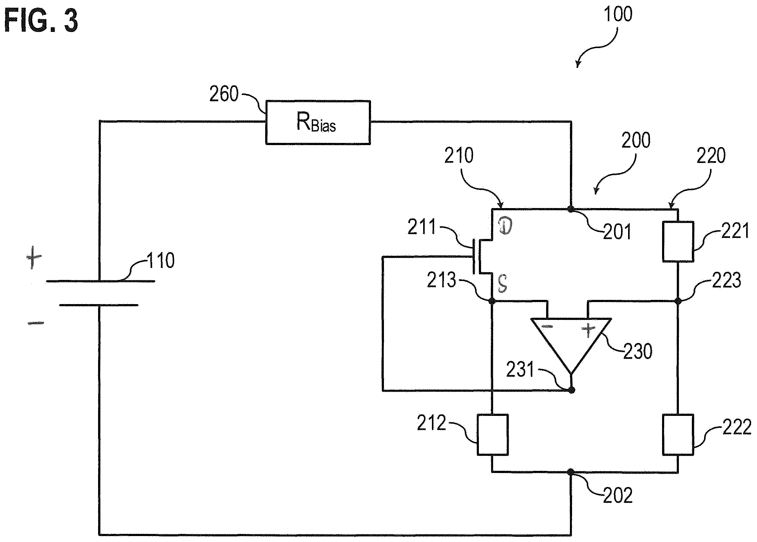

**FIG.3** zeigt eine Messschaltung 100 gemäß verschiedenen Aspekten, die analog zu der Messschaltung 100 aus FIG.2A aufgebaut ist und zusätzlich einen Vorwiderstand 260 aufweist. Der Vorwiderstand kann ein elektrisches Widerstandsbauteil sein, das einen, z.B. konstanten, ohmschen Widerstand $R_{Bias}$ aufweist. Der Vorwiderstand 260 kann eingangsseitig mit der Leistungsquelle 110 verbunden sein. Ausgangsseitig kann der Vorwiderstand 260 mit der Brückenschaltung 200, beispielsweise dem Brückeneingangsknoten 201 verbunden sein. Die Leistungsversorgungsspannung Ucc kann, korrespondierend zu dem ohmschen Widerstand $R_{Bias}$ des Vorwiderstands 260, über dem Vorwiderstand 260 und der Brückenschaltung 200 abfallen. Basierend darauf, kann beispielsweise die Brückenspannung $U_{Bias}$ berechnet werden.

Gemäß verschiedenen Aspekten können in der Messschaltung 100 verschiedene Messsignale ermittelt werden. Die ermittelten Messsignale können an einen Signalwandler übermittelt werden. Der Signalwandler kann eingerichtet sein, Messsignale einer ersten Art in Messsignale einer zweiten Art umzuwandeln, um beispielsweise eine Weiterverarbeitung der Messsignale vorzubereiten. Beispielsweise kann der Signalwandler ein Analog-Digital-Wandler (ADC) sein, der eingerichtet ist, ein analoges Messsignal in ein digitales Messsignal umzuwandeln. Dazu kann die Messschaltung 100 mit einem Signalwandler verbunden sein oder diesen aufweisen. Beispielsweise kann der ADC mit einem Mikrocontroller gekoppelt sein, z.B. in diesem implementiert (z.B. realisiert) sein. Beispielsweise kann der ADC eine Leistung von einem Mikrocontroller beziehen. Beispielsweise kann das ADC von der Operationsverstärker-Leistungsquelle 245 mit einer Leistung versorgt werden.

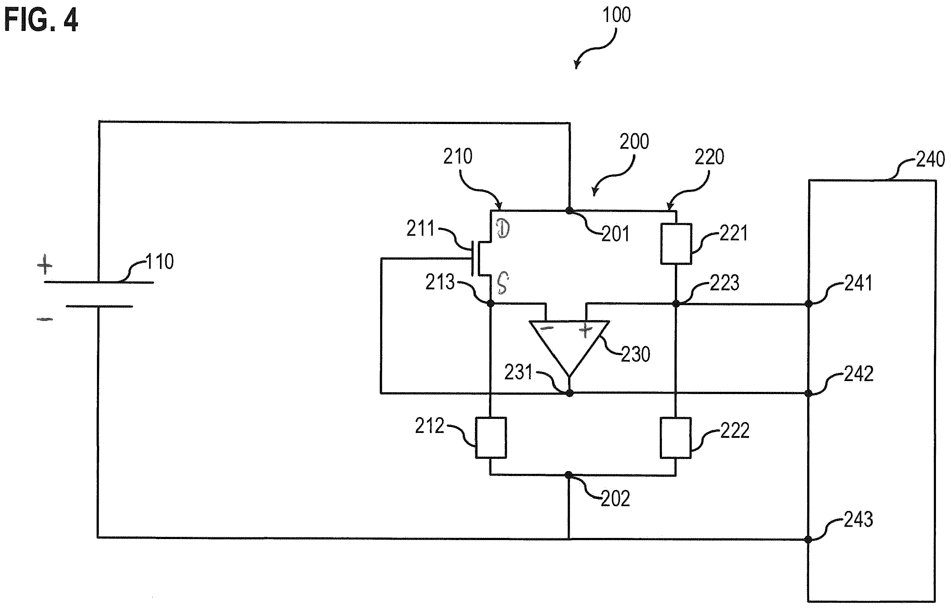

In **FIG.4** ist eine Messschaltung 100 gemäß verschiedenen Aspekten dargestellt. Die Messschaltung 100 ist analog zu der Messschaltung 100 aus FIG.2A aufgebaut, wobei die Messschaltung in FIG.4 ferner einen ADC 240 aufweist. Beispielsweise kann ein erster Anschluss 241 des ADC 240 mit dem zweiten Brückenknoten 223 verbunden sein. Somit kann der erste Anschluss 241 auf dem gleichen elektrischen Potential wie der zweite Brückenknoten 223 sein. Beispielsweise kann ein zweiter Anschluss 242 des ADC 240 mit dem Ausgabeknoten 231 verbunden sein. Somit kann der zweite Anschluss 242 auf dem gleichen elektrischen Potential wie der Ausgabeknoten 231 sein. Beispielsweise kann ein dritter Anschluss 243 des ADC 240 mit dem Brückenausgangsknoten 202 verbunden sein. Somit können der dritte Anschluss 243, der Brückenausgangsknoten 202 und ein zweiter Anschluss der Leistungsquelle 110 auf dem gleichen elektrischen Potential sein.

Der ADC 240 kann eingerichtet sein, ein erstes Messsignal $U_1$ mittels des ersten Anschlusses 241 und ein zweites Messsignal $U_2$ mittels des zweiten Anschlusses 242 zu erfassen.

Beispielsweise können das erste Messsignal $U_1$ und das zweite Messsignal $U_2$ jeweils einen Spannungswert repräsentieren. Beispielsweise kann das erste Messsignal $U_1$ die Offsetspannung $U_{ofs}$ repräsentieren (z.B. sein). Beispielsweise dazu, kann das erste Messsignal $U_1$ Brückenspannung $U_{Bias}$ repräsentieren (z.B. sein), wenn diese (alternativ zur Fig.4) am Brückeneingangsknoten 201 ermittelt wird, was jedoch zu einer größeren Messungenauigkeit führen kann, z.B. abhängig von einem Widerstand des zweiten Widerstandsbauteils 221. Beispielsweise kann das zweite Messsignal $U_2$ die experimentell ermittelte Ausgangsspannung $U_{Ref,exp}$ repräsentieren (z.B. sein).

Beispielsweise kann der Wert der Offsetspannung $U_{ofs}$ und/oder der Brückenspannung $U_{Bias}$ basierend auf dem ersten Messsignal $U_1$ ermittelt werden.

Beispielsweise kann das zweite Messsignal $U_2$ unter Verwendung des ersten Messsignals $U_1$ korrigiert werden. Beispielsweise können das erste Messsignal $U_1$ und das zweite Messsignal $U_2$ verwendet werden, um die zu ermittelnde Ausgangsspannung $U_{ref}$ zu ermitteln. Dazu kann beispielsweise das erste Messsignal $U_1$, z.B. der Wert der Offsetspannung $U_{ofs}$, von dem zweiten Messsignal $U_2$ abgezogen werden:

$$U_{Ref} = U_2 - U_1 = U_{Ref,exp} - U_{\text{ofs}} \qquad (8)$$

Beispielsweise kann mittels dieser Subtraktion ein Offset, der durch eine Topologie der Schaltung selbst zustande kommt, korrigiert werden. Im Detail kann dieser Offset dadurch erzeugt werden, dass ein Source-Anschluss des FET 211 nicht auf einem Masse-Potential liegt, sondern aufgrund des ersten Widerstandsbauteils 212 auf ein bestimmtes Potential, die Offsetspannung $U_{ofs}$ angehoben wird.

Alternativ oder zusätzlich kann das zweite Messsignal $U_2$ ein Einfluss der Brückenspannung $U_{Bias}$ (z.B. Änderungen der Brückenspannung $U_{Bias}$) auf das zweiten Messsignal $U_2$ korrigiert werden. Beispielsweise kann der Einfluss der Brückenspannung $U_{Bias}$ auf das zweite Messsignal $U_2$ lediglich von den ohmschen Widerstandswerten der in der Messschaltung 100 verwendeten elektrischen Widerstandsbauteile abhängen: dem des ersten Widerstandsbauteils 212, dem des zweiten Widerstandsbauteils 221, dem des dritten Widerstandsbauteils 222 und, sofern vorhanden, dem des Vorwiderstands 260:

$$C = f(R_1, R_2, R_3, R_{Bias}) \qquad (9)$$

Beispielsweise kann die Korrektur des zweiten Messsignals $U_2$ von dem Einfluss der Brückenspannung $U_{Bias}$ mittels einer Kalibrierung durchgeführt werden. Beispielsweise kann dazu bei einer vorbestimmten Leistungsversorgungsspannung Ucc (anschaulich einer Batteriespannung) eine Zweipunkt-Kalibrierung oder beispielsweise eine Dreipunkt-Kalibrierung durchgeführt werden. Dazu kann bei zwei bzw. drei voneinander verschiedenen aber bekannten pH-Werten eine zugehörige Ausgangsspannung $U_{Ref}$ ermittelt werden.

Beispielsweise kann die vorbestimmte Leistungsversorgungsspannung Ucc innerhalb eines Bereichs (z.B. zwischen 1,40 V und 1,60 V) variieren, jedoch sollte die Leistungsversorgungsspannung Ucc während der Kalibrierung im Wesentlichen konstant sein, d.h. die Leistungsversorgungsspannung Ucc darf lediglich um einige Millivolt variieren (z.B. um weniger als 20 mV).

Beispielsweise kann zur Kalibrierung mittels des ADC 240 eine Brückenspannung $U_{Bias}$ als erstes Messsignal $U_1$ und eine gemessene Ausgangsspannung $U_{Ref,exp}$ als zweites Messsignal $U_2$ ermittelt werden. Beispielsweise können das erste und zweite Messsignal $U_1$, $U_2$ mittels eines Mikrocontrollers ermittelt werden und können anschließend von diesem nichtflüchtig gespeichert werden. Das erste Messsignal $U_1$ kann für alle pH-Werte im Verlauf des Kalibrierungsvorgangs und während späterer Messvorgänge gleich sein und kann als Norm-Wert (oder auch als Normalwert) $U_{1,Norm}$

im nichtflüchtigen Speicher gespeichert werden. Beispielsweise kann basierend auf dem Normwert $U_{1,Norm}$ die Leistungsversorgungsspannung Ucc direkt ermittelt werden.

Bei Messungen, z.B. um einen unbekannten pH-Wert zu ermitteln, können nach der Kalibrierung, wie zuvor beschrieben, ein erstes Messsignal $U_1$ und ein zweites Messsignal $U_2$ mittels des ADC 240 ermittelt werden. Anschließend kann eine Differenz $\Delta U_1$ (z.B. $\Delta U_{Bias}$) zwischen dem neu ermittelten ersten Messsignal $U_1$ (z.B. einer neu ermittelten Brückenspannung $U_{Bias}$) und dem gespeicherten Normwert $U_{1,Norm}$ (z.B. einer gespeicherten Norm-Brückenspannung $U_{Bias,Norm}$) gebildet werden. Die Differenz kann mit dem Korrekturfaktor C multipliziert und vom zweiten Messsignal $U_2$ abgezogen werden, um die zu ermittelnde Ausgangsspannung $U_{Ref}$ zu ermitteln:

$$U_{Ref} = U_2 - C \cdot \left(U_{1,Norm} - U_1\right) = U_{Ref,exp} - C \cdot \left(U_{Bias,Norm} - U_{Bias}\right) \qquad (10)$$

Der Korrekturterm C ist unter anderem von dem ohmschen Widerstand $R_1$ des ersten elektrischen Widerstandsbauteils 212 abhängig. Diese Abhängigkeit kann damit begründet werden, dass der Drainstrom $I_D$ über das erste elektrische Widerstandsbauteil 212 fließt. In einem Ausführungsbeispiel kann der erste Brückenzweig 210 separat mit Leistung versorgt werden, um den Einfluss des ersten elektrischen Widerstandsbauteils 212 zu reduzieren. In einem solchen Fall würden jedoch zumindest ein zusätzlicher Operationsverstärker und gegebenenfalls ein zusätzlicher Transistor benötigt werden.

Das Ergebnis ist ein korrigierter Wert der zu ermittelnden Ausgangsspannung $U_{Ref}$, wie er sich ergeben würde, läge wieder die gleiche Batteriespannung an wie zum Zeitpunkt der Kalibrierung. Durch die zusätzliche Korrektur der Leistungsversorgungsspannung Ucc, wie oben beschrieben, kann der Einfluss der Leistungsversorgungsspannung Ucc auf die zu ermittelnden Ausgangsspannung $U_{Ref}$ zusätzlich korrigiert werden:

$$U_{Ref} = U_{Ref,exp} - \Delta U_{CC} \cdot D - \Delta U_{Bias} \cdot C \qquad (11)$$

Beispielsweise ermöglicht der ermittelte Wert der Brückenspannung $U_{Bias}$, eine aktuelle Leistungsversorgungsspannung Ucc zu ermitteln. Die aktuelle Leistungsversorgungsspannung Ucc kann beispielsweise einen Ladezustand der Leistungsversorgung 110 repräsentieren, welcher beispielsweise für mobile Vorrichtungen wichtig sein kann. Beispielsweise kann basierend auf der aktuellen Leistungsversorgungsspannung Ucc eine Batteriespannungsüberwachung, eine sogenannte Low-Batterie-Detection, implementiert werden (z.B. für eine mobile Vorrichtung).

Zusammenfassend ermöglicht die Ermittlung des ersten Messsignals U1 eine Korrektur des zweiten Messsignals U2 basierend direkt auf dem ersten Messsignal U1 und/oder auf dem Korrekturterm C. Diese Korrektur ermöglicht es beispielsweise, eine Leistungsquelle 110 in der Messschaltung 100 zu verwenden, die nicht langzeitstabil sein muss, d.h. die Leistungsquelle muss keine konstante Leistung bereitstellen über einen Zeitraum von mehr als einem Tag, z.B. mehr als einer Woche, z.B. mehr als einem Monat, z.B. mehr als einem Jahr. Ferner ermöglicht die Ermittlung des ersten Messsignals U1 und zweiten Messsignals U2 eine Überwachung der Leistungsquelle, z.B. mittels einer Spannungsüberwachung (z.B. eine Batteriespannungsüberwachung).

Gemäß verschiedenen Aspekten kann der ADC 240 dazu eingerichtet sein, das erste Messsignal $U_1$ zeitgleich mit dem zweiten Messsignal $U_2$ zu erfassen. Alternativ dazu, kann der ADC 240 dazu eingerichtet sein, das erste Messsignal $U_1$ und das zweite Messsignal $U_2$ nacheinander zu erfassen. Um mehrere zusammengehörige Messsignale nacheinander zu erfassen, kann es vorteilhaft sein, wenn während eines dazu korrespondierenden Messzeitraums die Leistungsversorgung konstant ist. Dies ermöglicht beispielsweise, dass gleiche Messbedingungen für die zusammengehörigen Messsignale gewährleistet sein können.

Gemäß verschiedenen Aspekten kann die Messschaltung 100 optional ferner einen Kondensator aufweisen, der es ermöglicht eine Kurzzeitstabilität der Messschaltung zu realisieren. Die Kurzzeitstabilität ermöglicht es beispielsweise eine konstante Leistungsversorgung für mehrere zusammengehörige (z.B. nacheinander folgende) Messungen bereitzustellen. Beispielsweise kann dabei eine elektrische Kapazität des Kondensators derart gewählt werden, dass diese ausreicht, um eine konstante Leistung in einem Zeitraum bereitzustellen, der mit dem Beginn einer ersten Messung der mehreren Messungen beginnt und mit dem Ende einer letzten der mehreren Messungen endet. Somit kann während der gesamten Messdauer eine konstante Leistung bereitgestellt werden.

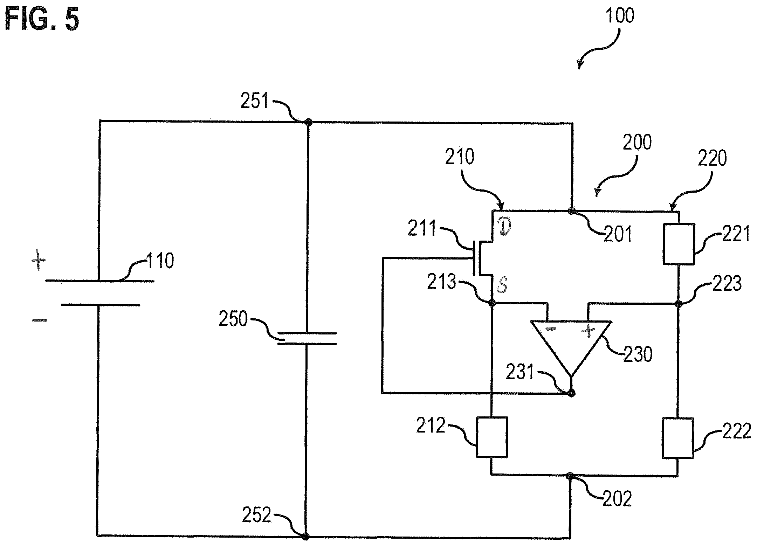

FIG.5 zeigt eine Messschaltung 100 gemäß verschiedenen Aspekten, die analog zu der Messschaltung 100 aus FIG.2A ausgestaltet ist und ferner einen Kondensator 250 aufweist, um für nacheinander folgende Messungen eine konstante Leistungsversorgung bereitzustellen. Der Kondensator 250 kann parallel zur Brückenschaltung 200 geschaltet sein. Beispielsweise kann der Kondensator 250 zwischen einem ersten Kondensatorknoten 251 und einem zweiten Kondensatorknoten 252 geschaltet sein. Der erste Kondensatorknoten 251 kann mit dem Brückeneingangsknoten 201 verbunden sein und somit auf dem gleichen elektrischen Potential wie der Brückeneingangsknoten 201 sein. Wenn die Messschaltung ferner einen Vorwiderstand 260 aufweist, kann der erste Kondensatorknoten 251 mit einem Ausgang des Vorwiderstands verbunden sein, analog zum Brückeneingangsknoten 201. Der zweite Kondensatorknoten 252 kann mit dem Brückenausgangsknoten 202 verbunden sein und somit auf dem gleichen elektrischen Potential wie der Brückenausgansknoten 202 sein. Wenn der Brückenausgangsknoten 202 ferner mit einem dritten Ausgang 243 eines ADC 240 verbunden ist, kann auch der dritte Ausgang 243 auf dem gleichen elektrischen Potential wie der zweite Kondensatorknoten 252 sein.

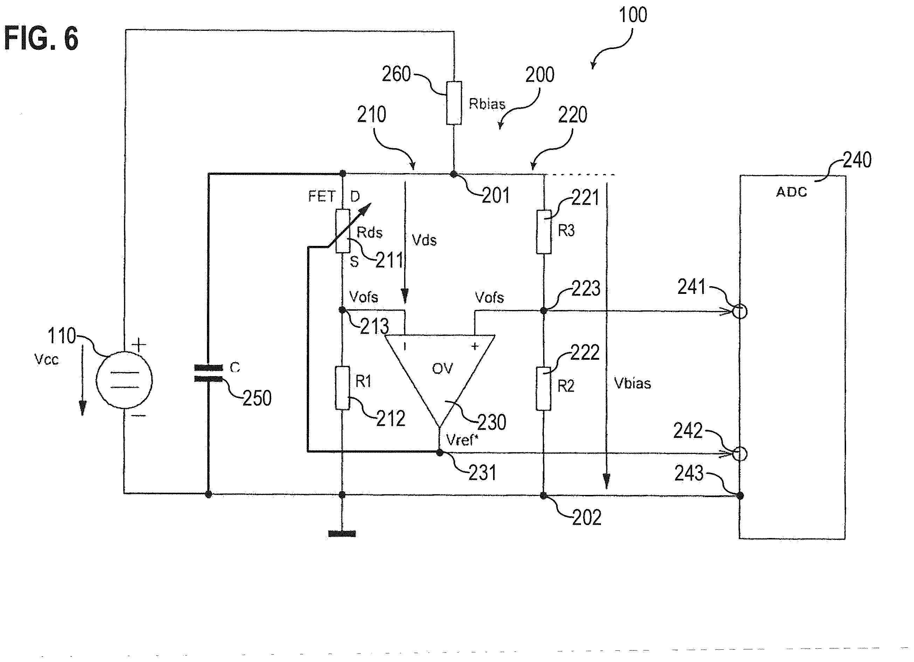

Gemäß verschiedenen Aspekten, können die hierin als optional bezeichneten Bauteile alle miteinander kombiniert werden. **FIG.6** stellt eine Messschaltung 100 gemäß verschiedenen Aspekten dar, die analog zu den Messschaltungen der Figuren 2A bis 5 ausgestaltet ist, wobei die in den Figuren 3 bis 5 als optional gekennzeichneten elektronischen Bauteile vorhanden sind.

Gemäß verschiedenen Aspekten kann die hierin beschriebene Messschaltung 100 kalibriert werden. Aufgrund der oben beschriebenen Korrektur wurde erkannt, dass für die Messschaltung eine zweipunkt oder dreipunkt-Kalibrierung ausreichend ist. Bei dieser Kalibrierung können die Messsignale für eine erste bekannte Konzentration und eine zweite bekannte Konzentration eines vorbestimmten Stoffes ermittelt werden, und eine lineare Anpassung kann basierend auf den ermittelten Messsignalen durchgeführt werden (Zweipunkt-Kalibrierung). Beispielsweise können zusätzlich die Messsignale für eine dritte bekannte Konzentration des vorbestimmten Stoffes ermittelt werden, und basierend auf den Messsignalen, die zu den drei verschiedenen Konzentrationen korrespondieren, kann eine Kalibrierung (z.B. eine lineare Anpassung) durchgeführt werden (Dreipunkt-Kalibrierung).

Gemäß verschiedenen Aspekten kann die Messschaltung mit einem Mikrocontroller gekoppelt (z.B. verbunden) sein. Beispielsweise kann der ADC 240 in dem Mikrocontroller implementiert sein (z.B. mittels des Mikrocontrollers realisiert sein). Der Mikrocontroller kann beispielsweise einen Prozessor aufweisen. Der Mikrocontroller kann beispielsweise dazu eingerichtet sein, die hierin beschriebenen Berechnungen und/oder Verfahren durchzuführen. Gemäß verschiedenen Aspekten kann der Mikrokontroller einen Speicher aufweisen, auf dem eine Kalibrierung gespeichert werden kann und/oder gespeichert ist.

Beispielsweise kann der Mikrocontroller eingerichtet sein, zumindest zwei, drei oder mehr als drei vorbestimmte Kalibrierwerte zu speichern. Beispielsweise kann der Mikrocontroller eingerichtet sein, zu jedem der vorbestimmten Kalibrierwerte eine zugehörige Zeit zu speichern. Beispielsweise kann der Mikrocontroller eingerichtet sein, das erste Messsignal $U_1$ (am ersten Anschluss 241 des ADC 240) und/oder einen daraus berechneten Zwischenwert (z.B. eine Leistungsversorgungsspannung Ucc) nichtflüchtig im Speicher des Mikrocontrollers zu speichern. Beispielsweise kann zu jedem der gespeicherten Werte ebenfalls eine Zeit gespeichert werden, z.B. die zu dem Zeitpunkt korrespondiert, an dem das jeweilige Messsignal erfasst wurde. Beispielsweise können die gespeicherten Werte verwendet werden, um eine Messwertkorrektur durchzuführen, obwohl sich eine bereitgestellte Leistung (z.B. eine Leistungsversorgungsspannung Ucc, ein Leistungsversorgungsstrom) der Leistungsquelle verändert hat.

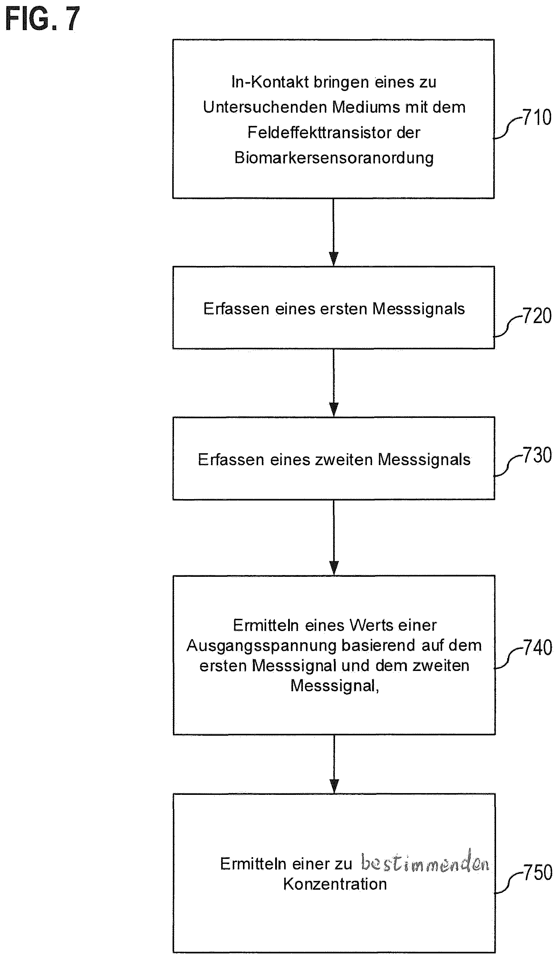

**FIG.7** stellt schematisch ein Verfahren 700 zum Betreiben einer hierin beschriebenen Messschaltung 100, z.B. einer Biomarkersensoranordnung, dar. Das Verfahren kann aufweisen, In-Kontakt bringen 710 eines zu untersuchenden Mediums mit dem Feldeffekttransistor 211 der Messschaltung 100. Das zu untersuchende Medium kann eine zu ermittelnde Konzentration eines vorbestimmten Stoffes aufweisen. Beispielsweise kann eine Konzentration, die unterhalb eines vorbestimmten Grenzwerts liegt, die Abwesenheit des vorbestimmten Stoffes (z.B. eine Konzentration von 0) repräsentieren. Beispielsweise kann es sich bei dem vorbestimmten Stoff um einen Biomarker handeln.

Anschließend kann ein erstes Messsignal erfasst werden 720, das eine Brücken-Spannung zwischen einem Brückeneingangsknoten 201 und einem Brückenausgangsknoten 202 repräsentiert. Ferner kann ein zweites Messsignal erfasst werden 730, das eine Gate-Spannung eines Feldeffekttransistors 211 repräsentiert. Das zweite Messsignal und das erste Messsignal können zeitgleich oder nacheinander erfasst werden (z.B. mittels eines ADC).

Basierend auf dem ersten Messsignal und dem zweiten Messsignal kann eine zu ermittelnde Ausgangsspannung ermittelt werden 740. Die zu ermittelnde Ausgangsspannung kann beispielsweise die zu ermittelnde Konzentration des Stoffs innerhalb des zu untersuchenden Mediums repräsentieren.

Anschließend kann basierend auf der ermittelten Ausgangsspannung die zu ermittelnde, anders ausgedrückt die zu bestimmende Konzentration ermittelt werden 750. Beispielsweise kann die Konzentration basierend auf einer Kalibrierung der Messschaltung ermittelt werden. Beispielsweise kann die Konzentration mittels einer Kalibrierung berechnet werden.

Gemäß verschiedenen Aspekten wird eine Messschaltung bereitgestellt, die einen ChemFET und/oder einen ISFET aufweist. Derartige Feldeffekttransistoren können eine zu ermittelnde Stoffkonzentration zuverlässig bestimmen und können aufgrund ihrer Eigenschaften für eine Verwendung in einem mobilen Gerät geeignet sein (z.B. nur eine Energiequelle notwendig, wenig Platzbedarf, geringe Anzahl von Bauteilen, geringer Energieverbrauch).

Gemäß verschiedenen Aspekten wird eine Messschaltung bereitgestellt, die in einem kleinen geometrischen Maßstab umgesetzt werden oder sein kann. Somit kann ein geeigneter Mikrocontroller unmittelbar in die Messschaltung integriert und/oder mit dieser gekoppelt werden. Gemäß verschiedenen Aspekten kann eine zu erfassende Messspannung linear von einer zu ermittelten Stoffkonzentration abhängig sein. Mittels einer Kalibrierung kann eine hohe Messgenauigkeit der Messschaltung ermöglicht werden. Gleichzeitig kann die zu erfassende Messspannung eine Überwachung einer Betriebsspannung einer Leistungsquelle der Messschaltung ermöglichen. Dies kann beispielsweise für mobile Geräte von Vorteil sein.

Beispielsweise kann die Messschaltung mit einer Auswerteeinheit gekoppelt sein. Beispielsweise kann die Messschaltung eingerichtet sein, die erfassten Messdaten an eine Auswertevorrichtung zu übertragen. Somit kann beispielsweise der Energieverbrauch der Messschaltung weiter reduziert sein/werden.

Gemäß verschiedenen Aspekten wird eine Messschaltung bereitgestellt, die ein Spannungssignal bereitstellt, das linear von einer zu ermittelten Stoffkonzentration abhängig ist.

Gemäß verschiedenen Aspekten wird eine Messschaltung bereitgestellt, die unmittelbar mittels eines Mikrocontrollers gesteuert werden kann.

Gemäß verschiedenen Aspekten wird eine Messschaltung bereitgestellt, die keine zusätzliche Leistungsquelle (z.B. eine Stromquelle oder einer Spannungsquelle) benötigt.

Gemäß verschiedenen Aspekten wird eine Messschaltung bereitgestellt, die weniger als 10 Bauteile (z.B. 7, 8, 9) benötigt, und somit auf sehr kleinem Bauraum umsetzbar ist.

Gemäß verschiedenen Aspekten wird eine Messschaltung bereitgestellt, die einen sehr geringen Energieverbrauch aufweist.

Gemäß verschiedenen Aspekten wird eine Messschaltung bereitgestellt, mittels derer Messdauern von weniger als 100 ms (z.B. weniger als 50 ms, z.B. weniger als 10 ms) realisiert werden können.

Beispielsweise kann statt der Ausgangsspannung $U_{ref}$, die z.B. auch als die Spannung zwischen Gate und Source $U_{GS}$ bezeichnet werden kann - siehe hierzu beispielsweise FIG.4, ein Potential an einem Gate-Anschluss (z.B. ermittelt am Ausgabeknoten 231 und/oder am zweiten Anschluss 242) bezogen auf eine Masse (z.B. ermittelt am Brückenausgangsknoten 202 und/oder am dritten Anschluss 243) ermittelt werden, z.B. gemessen werden.

Das am Gate-Anschluss ermittelte Potential kann zusätzlich zu der Spannung zwischen Gate und Source $U_{GS}$ eine Spannung enthalten, die an R1 anfällt und die auch als Offsetspannung $U_{ofs}$ bezeichnet werden kann. Um die Ausgangsspannung $U_{ref}$ zu ermitteln kann daher die Offsetspannung $U_{ofs}$ vom Messwert abgezogen werden. Dies stellt eine Korrektur des Messwerts dar, z.B. eine erste Korrektur.

Beispielsweise kann die Offsetspannung $U_{ofs}$ auf Grundlage einer Brückenspannung $U_{Bias}$ mit Hilfe der Brückengleichung ermittelt werden. Die Brückenspannung $U_{Bias}$ kann beispielsweise am Brückeneingangsknoten 201 ermittelt werden. Beispielsweise können das zweite und dritte Widerstandsbauteil als ein Spannungsteiler fungieren. Dazu kann es notwendig sein die Brückenspannung $U_{Bias}$ zu messen. Der Messwert der Brückenspannung $U_{Bias}$ kann zusätzlich zu einer Batteriespannungskontrolle, die auch als eine Batterieüberwachung bezeichnet werden kann, ausgewertet werden.

Beispielsweise kann die Offsetspannung $U_{ofs}$ dem vorhandenen Spannungsteiler, beispielsweise an einem Verbindungspunkt der des zweiten Widerstandsbauteils $R_2$ und des dritten Widerstandsbauteils $R_3$, wie z.B. dem zweiten Brückenknoten 223 und/oder dem ersten Anschluss 241. Dies ist beispielhaft in FIG.4 dargestellt. Somit kann ein Wert für die Offsetspannung $U_{ofs}$ direkt ermittelt werden, z.B. mittels einer Messung. Beispielsweise kann zusätzlich basierend auf der Offsetspannung $U_{ofs}$ die Batteriespannung ermittelt werden, um eine Batteriespannungskontrolle durchzuführen. Beispielsweise ermöglicht die direkte Ermittlung, dass beide Messspannungen in etwa im gleichen Bereich liegen und daher kein zusätzlicher Spannungsteiler benötigt wird. Basierend darauf können sich folgende Ausdrücke zum Berechnen von der Ausgangsspannung $U_{ref}$ und der Leistungsversorgungsspannung $U_{cc}$ aus einem Spannungsmesswert $U_{241}$ am ersten Anschluss 241 und einem Spannungsmesswert $U_{242}$ ergeben:

$$U_{Ref} = U_{242} - U_{241} \qquad (12)$$

$$U_{CC} = U_{241} \cdot \frac{R_2 + R_3}{R_3} \qquad (13)$$

Beispielsweise können die Brückenspannung $U_{Bias}$ und die Leistungsversorgungsspannung Ucc schwanken. Beispielsweise kann das Messsystem kalibriert werden, beispielsweise mittels einer Zweipunkt-Kalibrierung und/oder einer Dreipunkt-Kalibrierung, bei zwei bekannten Konzentrationen (Zweipunkt-Kalibrierung) bzw. bei drei bekannten Konzentrationen einer Messflüssigkeit (Dreipunkt-Kalibrierung). Bei der jeweiligen Kalibrierung kann eine bestimmte Betriebsspannung vorliegen, beispielsweise eine bestimmte Brückenspannung $U_{Bias}$ und eine bestimmte Leistungsversorgungsspannung Ucc.

Beispielsweise kann die Betriebsspannung Langzeit-stabilisiert sein, d.h. dass sich die Betriebsspannung über einen vordefinierten Zeitraum, z.B. mehrere Tage oder Wochen, nicht oder nur gering (z.B. weniger als 10%) ändert. Beispielsweise kann zu an einem *späteren* Zeitpunkt innerhalb des Zeitraums dieselbe Betriebsspannung anliegen, wie zum Zeitpunkt der Kalibrierung. In einem solchen Fall kann es für eine Berechnung der Ausgangsspannung $U_{Ref}$ ausreichend sein, die oben genannte Formel, d.h. ein Abziehen der Offsetspannung $U_{ofs}$ bzw. des Spannungsmesswert $U_{241}$ am ersten Anschluss 241 vom Messwert, unter nachfolgender Anwendung der jeweiligen Kalibrierung durchzuführen.

Alternativ dazu kann die Betriebsspannung zu einem Zeitpunkt, an dem eine Messung vorgenommen wird, von dem Wert abweichen, den sie zum Zeitpunkt der Kalibrierung hatte. In diesem Fall kann eine zweite Korrektur durchgeführt werden, um einen Einfluss von Schwankungen der Betriebsspannung auszugleichen.

Hierbei kann unter einer "Betriebsspannungsschwankung", z.B. auch als "Schwankung einer Betriebsspannung" bezeichnet, verstanden werden, dass die Betriebsspannung einen anderen unbekannten Wert hat als den zum Zeitpunkt der Kalibrierung (z.B. verursacht durch eine langsam schwächer werdende Batterie). Unter der "Betriebsspannungsschwankung" soll jedoch nicht verstanden werden, dass die Betriebsspannung irgendwie "wild" und unkontrolliert hin- und her springt oder "wackelt".

Weil der konkrete Wert der Betriebsspannung, beispielsweise eine Drain-Source-Spannung $U_{DS}$ des Feldeffekttransistors 211, jedoch einen Spannungswert der Gate-Source-Spannung des Feldeffekttransistors 211 beeinflusst, kann dieser Einfluss zusätzlich berücksichtigt werden. Dieser Einfluss kann beispielsweise sehr genau berechnet werden.

Beispielsweise kann eine Differenz zwischen dem aktuellen Wert der Betriebsspannung zum Messzeitpunkt, z.B. der Brückenspannung $U_{Bias}$ und/oder der Leistungsversorgungsspannung Ucc, und einem Wert der Betriebsspannung zum Zeitpunkt der Kalibrierung, z.B. der Brückenspannung $U_{Bias-cal}$ und/oder der Leistungsversorgungsspannung $U_{CC-cal}$, gebildet werden. Beispielsweise kann es dazu notwendig sein, den Wert der Betriebsspannung zum Zeitpunkt der Kalibrierung zu speichern. Anschließend kann die Differenz unter Beibehaltung des Vorzeichens, mit folgender Formel multipliziert werden, um einen zweiten Korrekturwert zu erhalten.

$$U_{Korr2} = (U_{CC} - U_{CC-cal}) \cdot \frac{R_3}{2 \cdot (R_2 + R_3)} \qquad (14)$$

Der zweite Korrekturwert kann zusätzlich zur Offsetspannung $U_{ofs}$ von der am ersten Brückenknoten 213 gemessenen Spannung abgezogen werden. Beispielsweise gilt folgende Formel für FIG. 4:

$$U_{Ref} = U_{242} - (U_{CC} - U_{CC-cal}) \cdot \frac{R_3}{2 \cdot (R_2 + R_3)} \qquad (15)$$

In welcher Reihenfolge die beiden Korrekturwerte vom Messwert abgezogen werden, ist egal.

Beispielsweise kann auf eine Berechnung eines konkreten Wertes der Betriebsspannung verzichtet werden, z.B. indem für eine Batteriespannungsüberwachung in einem korrespondierenden Mikrocontroller geeignete Schwellwerte/Tabellen für die ADC-Messwerte am ersten Anschluss 241 hinterlegt sind. In einem derartigen Fall kann sich beispielsweise eine vereinfachte Gesamtformel ergeben:

$$U_{Ref} = U_{242} - U_{241} - \frac{(U_{241} - U_{241-cal})}{2} \qquad (16)$$

wobei $U_{241-cal}$ der Spannungswert am ersten Anschluss zum Zeitpunkt der Kalibrierung und $U_{241}$ der Spannungswert am ersten Anschluss zum Messzeitpunkt ist. Dazu kann es notwendig sein, den Spannungswert am ersten Anschluss zum Zeitpunkt $U_{241-cal}$ zu speichern und wieder zu laden. Die Werte aller Widerstände fallen dabei raus und somit kann ein tatsächlicher Wert für die Ausgangsspannung $U_{Ref}$ direkt aus den Spannungen an dem ersten und zweiten Ausgang 242 und 241 ermittelt werden. Beispielsweise muss in diesem Fall auch der in FIG. 6 vorhandene zusätzliche Vorwiderstand 260 Rbias nicht berücksichtigt werden.

Im Folgenden werden einige Beispiele beschrieben, die sich auf das hierin Beschriebene und in den Figuren Dargestellte beziehen.

Beispiel 1 ist eine aktive Messschaltung, die aufweisen kann:

eine elektrische Leistungsquelle, eine Brückenschaltung, wobei ein Brückeneingangsknoten der Brückenschaltung und ein Brückenausgangsknoten der Brückenschaltung mit der elektrischen Leistungsquelle verbunden sind,

einen ersten Brückenast der Brückenschaltung zwischen dem Brückeneingangsknoten und dem Brückenausgangsknoten, wobei der erste Brückenast einen Transistor und ein erstes Widerstandsbauteil aufweist, wobei ein zweites Widerstandsbauteil und ein drittes Widerstandsbauteil einen zweiten Brückenast der Brückenschaltung zwischen dem Brückeneingangsknoten und dem Brückenausgangsknoten bilden, wobei ein Operationsverstärker einen Brückenzweig zwischen dem ersten Brückenast und dem zweiten Brückenast der Brückenschaltung bildet, und wobei der Operationsverstärker mit einem Gate-Kontakt des Feldeffekttransistors verbunden ist.

Beispiel 2 ist eine aktive Messschaltung gemäß Beispiel 1, wobei der Transistor ein organischer elektrochemischer Transistor (OECT) oder ein chemisch aktiver Feldeffekttransistor oder ein ionenempfindlicher Feldeffekttransistor sein kann.

Beispiel 3 ist eine aktive Messschaltung gemäß Beispiel 1 oder 2, wobei zwischen dem Transistor und dem ersten Widerstandsbauteil des ersten Brückenasts der Brückenschaltung ein erster Brückenknoten angeordnet sein kann, der mit einem ersten Eingang des Operationsverstärkers verbunden ist, und wobei zwischen dem zweiten Widerstandsbauteil und dem dritten Widerstandsbauteil des zweiten Brückenasts der Brückenschaltung ein zweiter Brückenknoten angeordnet sein kann, der mit einem zweiten Eingang des Operationsverstärkers verbunden ist, und wobei ein Ausgabeknoten des Operationsverstärkers und/oder der zweite Brückenknoten zum Ausgeben eines von mindestens einem Messsignal, beispielsweise zum Anschließen und Betreiben eines Analog-Digital-Wandlers, eingerichtet ist.

Beispiel 4 ist eine aktive Messschaltung gemäß Beispiel 3, die ferner optional aufweisen kann: einen Analog-Digital-Wandler der eingerichtet sein kann, um das mindestens eine Messsignal von dem Operationsverstärker , und/oder von dem Brückenausgangsknoten und/oder von dem zweiten Brückenknoten zu empfangen. Beispielsweise kann der Analog-Digital-Wandler eingerichtet sein, um das mindestens eine Messsignal in ein digitales Messsignal umzuwandeln. Beispielsweise kann das mindestens eine Messsignal mehrere Messsignale aufweisen. Beispielsweise kann der Analog-Digital-Wandler eingerichtet sein von dem zweiten Brückenknoten ein erstes Messsignal von den mehreren Messsignalen zu empfangen. Beispielsweise kann der Analog-Digital-Wandler eingerichtet sein von dem Operationsverstärker ein zweites von den mehreren Messsignalen zu empfangen. Beispielsweise kann der Analog-Digital-Wandler eingerichtet sein von dem Brückenausgangsknoten ein drittes von den mehreren Messsignalen zu empfangen.

Beispiel 5 ist eine aktive Messschaltung gemäß Beispiel 1 oder 2, wobei zwischen dem Transistor und dem ersten Widerstandsbauteil des ersten Brückenasts der Brückenschaltung ein erster Brückenknoten angeordnet sein kann, der mit einem ersten Eingang des Operationsverstärkers verbunden sein kann, und zwischen dem zweiten Widerstandsbauteil und dem dritten Widerstandsbauteil des zweiten Brückenasts der Brückenschaltung ein zweiter Brückenknoten angeordnet sein kann, der mit einem zweiten Eingang des Operationsverstärkers verbunden ist, und wobei ein Ausgabeknoten des Operationsverstärkers, der Brückenausgangsknoten und der zweite Brückenknoten zum Betreiben (z.B. zum Anschließen und zum Betreiben) eines Analog-Digital-Wandlers eingerichtet sind, wobei der Analog-Digital-Wandler zum Ausgeben von mindestens einem Messsignal (z.B. einer Messspannung, eines Messstroms) eingerichtet ist.

Beispiel 6 ist eine aktive Messschaltung gemäß einem der Beispiele 3 bis 5, wobei das mindestens eine Messsignal eine elektrische Eigenschaft des Feldeffekttransistors repräsentieren kann, und wobei die elektrische Eigenschaft beispielsweise eine elektrische Leitfähigkeit, und/oder ein Status einer Raumladungszone des Transistors repräsentieren (z.B. sein) kann.

Beispiel 7 ist eine aktive Messschaltung gemäß einem der Beispiele 3 bis 6, wobei das mindestens eine Messsignal eine Konzentration eines vorbestimmten Stoffes (z.B. einen pH-Wert) repräsentieren kann.

Beispiel 8 ist eine aktive Messschaltung gemäß einem der Beispiele 3 bis 7, die optional ferner aufweisen kann einen Analog-Digital-Wandler, der eingerichtet ist, ein erstes Messsignal von einem Brückenknoten, der zwischen dem zweiten Widerstandsbauteil und dem dritten Widerstandsbauteil angeordnet ist, in ein erstes digitales Signal umzuwandeln und ein zweites Messsignal von einem Ausgabeknoten des Operationsverstärkers in ein zweites digitales Signal umzuwandeln; und einen Mikrocontroller, der eingerichtet ist, das erste digitale Messsignal und das zweite digitale Messsignal von dem Analog-Digital-Wandler zu empfangen, eine Referenzspannung unter Verwendung des ersten digitalen Signals und des zweiten digitalen Signals zu ermitteln, und eine Konzentration eines vorbestimmten Stoffes unter Verwendung der Referenzspannung zu ermitteln.

Beispiel 9 ist eine aktive Messschaltung gemäß Beispiel 4 oder 8, wobei ein erster Anschluss des Analog-Digital-Wandlers mit dem zweiten Brückenknoten verbunden sein kann, wobei ein zweiter Anschluss des Analog-Digital-Wandlers mit dem Ausgang des Operationsverstärkers verbunden sein kann, und wobei ein dritter Anschluss des Analog-Digital-Wandlers mit dem Brückenausgangsknoten verbunden sein kann.

Beispiel 10 ist eine aktive Messschaltung gemäß Beispiel 4, 8 oder 9, wobei der Analog-Digital-Wandler mit einem Mikrocontroller elektrisch gekoppelt sein kann und/oder Bestandteil von diesem sein kann.

Beispiel 11 ist eine aktive Messschaltung gemäß einem der Beispiele 1 bis 10, wobei der Ausgang des Operationsverstärkers mit dem Gate-Kontakt des Transistors, beispielsweise des Feldeffekttransistors, verbunden sein kann.

Beispiel 12 ist eine aktive Messschaltung gemäß einem der Beispiele 1 bis 11, wobei der Operationsverstärker eine separate Leistungsversorgung zur elektrischen Leistungsquelle aufweist. Beispielsweise kann die separate Leistungsversorgung des Operationsverstärkers parallel zur Brückenschaltung geschaltet sein.

Beispiel 13 ist eine aktive Messschaltung gemäß einem der Beispiele 1 bis 12, die ferner optional aufweisen kann, einen Kondensator der parallel zur Brückenschaltung geschaltet ist, wobei beispielsweise ein Eingangsknoten des Kondensators mit dem Brückeneingangsknoten und ein Ausgang des Kondensators mit dem Brückenausgangsknoten verbunden ist.

Beispiel 14 ist eine aktive Messschaltung gemäß einem der Beispiele 1 bis 13, die ferner optional aufweisen kann einen Vorwiderstand, der in Reihe mit der Brückenschaltung geschaltet ist, wobei beispielsweise ein Anschluss des Vorwiderstands mit der elektrischen Leistungsquelle und ein anderer Anschluss des Vorwiderstands mit dem Brückeneingangsknoten der Brückenschaltung verbunden ist.

Beispiel 15 ist eine aktive Messschaltung gemäß einem der Beispiele 1 bis 14, wobei die elektrische Leistungsquelle eingerichtet sein kann, eine Leistung von weniger als 750 $\mu$W (z.B. weniger als 500 $\mu$A und/oder 1,5 V), beispielsweise weniger als 150 $\mu$W (z.B. weniger als 100 $\mu$A und/oder 1,5 V), weiter beispielsweise weniger als 75 $\mu$W (z.B. weniger als 50 $\mu$A und/oder 1,5 V) bereitzustellen.

Beispiel 16 ist ein Verfahren zum Betreiben einer aktiven Messschaltung (z.B. als eine Biomarkersensoranordnung) gemäß einem der Beispiele 1 bis 12, wobei das Verfahren aufweist: In-Kontakt bringen eines zu Untersuchenden Mediums mit dem Transistor der aktiven Messschaltung; Erfassen eines ersten Messsignals, das eine Brücken-Spannung zwischen dem Brückeneingangsknoten und dem Brückenausgangsknoten repräsentiert, und/oder Erfassen eines zweiten Messsignals, das eine Gate-Spannung des Transistors repräsentiert; Ermitteln eines Werts einer Ausgangsspannung basierend auf dem ersten Messsignal und dem zweiten Messsignal; und Ermitteln einer zu bestimmenden Konzentration eines vorbestimmten Stoffes, die zu der Ausgangsspannung korrespondiert.

Beispiel 17 ist ein Verfahren zum Betreiben einer aktiven Messschaltung (z.B. als eine Biomarkersensoranordnung) gemäß einem der Beispiele 1 bis 14, wobei das Verfahren aufweisen kann: In-Kontakt bringen eines zu Untersuchenden Mediums mit dem Transistor der aktiven Messschaltung; Erfassen eines ersten Messsignals, das eine Brücken-Spannung zwischen dem Brückeneingangsknoten und dem Brückenausgangsknoten repräsentiert, und/oder Erfassen eines zweiten Messsignals, das eine Gate-Spannung des Transistors repräsentiert (z.B. Erfassen eines ersten Messsignals und eines zweiten Messsignals, wobei das erste Messsignal eine Brücken-Spannung zwischen dem Brückeneingangsknoten und dem Brückenausgangsknoten repräsentiert und das zweite Messsignal eine Gate-Spannung des Transistors repräsentiert); Ermitteln eines Werts einer Ausgangsspannung basierend auf dem ersten Messsignal und dem zweiten Messsignal; und Ermitteln einer zu bestimmenden Konzentration eines vorbestimmten Stoffes (z.B. einer Konzentration oder eines Vorhandenseins/einer Abwesenheit eines Biomarkers), die zu der Ausgangsspannung korrespondiert.

Beispiel 18 ist ein Verfahren gemäß Beispiel 17, wobei die ermittelte Konzentration direkt proportional zu der Ausgangsspannung ist.

Beispiel 19 ist ein Verfahren gemäß Beispiel 17 oder 18, wobei das Ermitteln eines Werts der Ausgangsspannung aufweisen kann: Ermitteln eines Korrekturwerts basierend auf dem ersten Messsignal (z.B. der Brücken-Spannung), einem ersten elektrischen Widerstand, der den elektrischen Widerstand des ersten Widerstandsbauteils repräsentiert, einem zweiten elektrischen Widerstand, der den elektrischen Widerstand des zweiten Widerstandsbauteils repräsentiert und einem dritten elektrischen Widerstand, der den elektrischen Widerstand des dritten Widerstandsbauteils repräsentiert.

Beispiel 20 ist ein Verfahren gemäß Beispiel 19, wobei der Korrekturwert auf einem Quotienten basieren kann (z.B. diesem entsprechen kann), der gebildet wird aus einem ersten Wert, der auf dem Produkt der Brücken-Spannung und dem zweiten elektrischen Widerstand basiert (z.B. diesem entspricht), und einem zweiten Wert, der auf der Summe des zweiten elektrischen Widerstands und des dritten elektrischen Widerstands basiert (z.B. diesem entspricht).

Beispiel 21 ist ein Verfahren gemäß einem der Beispiele 19 oder 20, wobei der Korrekturwert auf einem Quotienten basieren kann (z.B. diesem entsprechen kann), der gebildet wird aus einem ersten Wert, der auf dem Produkt der Brücken-Spannung und dem dritten elektrischen Widerstand basiert (z.B. diesem entspricht), und einem zweiten Wert, der auf dem Produkt aus der Summe des zweiten elektrischen Widerstands und des dritten elektrischen Widerstands als ersten Faktor mit dem ersten elektrischen Widerstand als zweiten Faktor basiert (z.B. diesem entspricht).

Beispiel 22 ist ein Verwenden einer Messschaltung gemäß einem der Beispiele 1 bis 15 oder eines Verfahrens gemäß einem der Beispiele 16 bis 21 zum Ermitteln einer Stoff-Konzentration (z.B. eines pH-Werts).

Beispiel 23 ist ein Verwenden einer Messschaltung gemäß einem der Beispiele 1 bis 15 oder eines Verfahrens gemäß einem der Beispiele 16 bis 21 zum Messen eines Vorhandenseins und/oder einer Menge eines Biomarkers in vivo.

**Patentansprüche**

1. Aktive Messschaltung (100) aufweisend:

    eine elektrische Leistungsquelle (110),
    eine Brückenschaltung (200), wobei ein Brückeneingangsknoten (201) der Brückenschaltung (200) und ein Brückenausgangsknoten (202) der Brückenschaltung (200) mit der elektrischen Leistungsquelle (110) verbunden sind,
einen ersten Brückenast (210) der Brückenschaltung (200) zwischen dem Brückeneingangsknoten (201) und dem Brückenausgangsknoten (202), wobei der erste Brückenast (210) einen Transistor (211) und ein erstes Widerstandsbauteil (212) aufweist,
wobei ein zweites Widerstandsbauteil (221) und ein drittes Widerstandsbauteil (222) einen zweiten Brückenast (220) der Brückenschaltung (200) zwischen dem Brückeneingangsknoten (201) und dem Brückenausgangsknoten (202) bilden,
wobei ein Operationsverstärker (230) einen Brückenzweig zwischen dem ersten Brückenast (210) und dem zweiten Brückenast (220) der Brückenschaltung (200) bildet, und
wobei der Operationsverstärker (230) mit einem Gate-Kontakt des Feldeffekttransistors (211) verbunden ist.

2. Aktive Messschaltung (100) gemäß Anspruch 1,
wobei der Transistor (211) ein organischer elektrochemischer Transistor oder ein chemisch aktiver Feldeffekttransistor oder ein ionenempfindlicher Feldeffekttransistor ist.

3. Aktive Messschaltung (100) gemäß Anspruch 1 oder 2,

wobei zwischen dem Transistor (211) und dem ersten Widerstandsbauteil (212) des ersten Brückenasts (210) der Brückenschaltung (200) ein erster Brückenknoten (213) angeordnet ist, der mit einem ersten Eingang des Operationsverstärkers (230) verbunden ist, und wobei zwischen dem zweiten Widerstandsbauteil (221) und dem dritten Widerstandsbauteil (222) des zweiten Brückenasts (220) der Brückenschaltung (200) ein zweiter Brückenknoten (223) angeordnet ist, der mit einem zweiten Eingang des Operationsverstärkers (230) verbunden ist, und
wobei ein Ausgabeknoten (231) des Operationsverstärkers (230) und/oder der zweite Brückenknoten (202) zum Ausgeben eines von mindestens einem Messsignal, insbesondere zum Anschließen und Betreiben eines Analog-Digital-Wandlers, eingerichtet ist.

4. Aktive Messschaltung (100) gemäß Anspruch 1 oder 2,

wobei zwischen dem Transistor (211) und dem ersten Widerstandsbauteil (212) des ersten Brückenasts (210) der Brückenschaltung (200) ein erster Brückenknoten (213) angeordnet ist, der mit einem ersten Eingang des Operationsverstärkers (230) verbunden ist, und wobei zwischen dem zweiten Widerstandsbauteil (221) und dem dritten Widerstandsbauteil (222) des zweiten Brückenasts (220) der Brückenschaltung (200) ein zweiter Brückenknoten (223) angeordnet ist, der mit einem zweiten Eingang des Operationsverstärkers (230) verbunden ist, und
wobei ein Ausgabeknoten (231) des Operationsverstärkers (230), der Brückenausgangsknoten (202) und der zweite Brückenknoten (223) zum Betreiben eines Analog-Digital-Wandlers eingerichtet sind, wobei der Analog-Digital-Wandler zum Ausgeben von mindestens einem Messsignal eingerichtet ist.

5. Aktive Messschaltung (100) gemäß einem der Ansprüche 3 bis 4,

wobei das mindestens eine Messsignal eine elektrische Eigenschaft des Transistors (211) und/oder eine Konzentration eines vorbestimmten Stoffes repräsentiert,
wobei die elektrische Eigenschaft vorzugsweise eine elektrische Leitfähigkeit, und/oder einen Status einer Raumladungszone des Transistors (211) repräsentiert.

6. Aktive Messschaltung (100) gemäß einem der Ansprüche 1 bis 5,
wobei die elektrische Leistungsquelle (110) eine Batterie ist.

7. Aktive Messschaltung (100) gemäß einem der Ansprüche 1 bis 6, ferner aufweisend:

einen Analog-Digital-Wandler (240), der eingerichtet ist, ein erstes Messsignal von einem Brückenknoten (223), der zwischen dem zweiten Widerstandsbauteil (221) und dem dritten Widerstandsbauteil (222) angeordnet ist, in ein erstes digitales Signal umzuwandeln und ein zweites Messsignal von einem Ausgabeknoten (231) des Operationsverstärkers (230) in ein zweites digitales Signal umzuwandeln; und
einen Mikrocontroller, der eingerichtet ist, das erste digitale Messsignal und das zweite digitale Messsignal von dem Analog-Digital-Wandler (240) zu empfangen, eine Referenzspannung unter Verwendung des ersten digitalen Signals und des zweiten digitalen Signals zu ermitteln, und eine Konzentration eines vorbestimmten Stoffes unter Verwendung der Referenzspannung zu ermitteln.

8.  Aktive Messschaltung (100) gemäß Anspruch 7,

    wobei ein erster Anschluss (241) des Analog-Digital-Wandlers (240) mit dem zweiten Brückenknoten (223) verbunden ist,
    wobei ein zweiter Anschluss (242) des Analog-Digital-Wandlers (240) mit dem Ausgang des Operationsverstärkers (230) verbunden ist, und
    wobei ein dritter Anschluss (243) des Analog-Digital-Wandlers (240) mit dem Brückenausgangsknoten (202) verbunden ist.

9.  Aktive Messschaltung (100) gemäß einem der Ansprüche 1 bis 8,
    wobei der Ausgang des Operationsverstärkers (230) mit dem Gate-Kontakt des Transistors (211) verbunden ist.

10. Aktive Messschaltung (100) gemäß einem der Ansprüche 1 bis 9 ferner aufweisend,

    einen Kondensator (250), der parallel zur Brückenschaltung (200) geschaltet ist,
    wobei vorzugsweise ein Eingangsknoten (251) des Kondensators (250) mit dem Brückeneingangsknoten und ein Ausgang des Kondensators (250) mit dem Brückenausgangsknoten (202) verbunden ist.

11. Aktive Messschaltung (100) gemäß einem der Ansprüche 1 bis 10 ferner aufweisend,

    einen Vorwiderstand (260), der in Reihe mit der Brückenschaltung (200) geschaltet ist,
    wobei vorzugsweise ein Anschluss des Vorwiderstands (260) mit der elektrischen Leistungsquelle (110) und ein anderer Anschluss des Vorwiderstands (260) mit dem Brückeneingangsknoten (201) der Brückenschaltung (200) verbunden ist.

12. Aktive Messschaltung (100) gemäß einem der Ansprüche 1 bis 11,
    wobei die elektrische Leistungsquelle (110) eingerichtet ist, eine Leistung von weniger als 750 $\mu$W, vorzugsweise weniger als 150 $\mu$W, weiter vorzugsweise weniger als 75 $\mu$W bereitzustellen.

13. Verfahren (700) zum Betreiben einer aktiven Messschaltung gemäß einem der Ansprüche 1 bis 12, wobei das Verfahren aufweist:

    In-Kontakt bringen (710) eines zu Untersuchenden Mediums mit dem Transistor (211) der aktiven Messschaltung;
    Erfassen eines ersten Messsignals (720), das eine Brücken-Spannung zwischen dem Brückeneingangsknoten (201) und dem Brückenausgangsknoten (202) repräsentiert, und/oder
    Erfassen eines zweiten Messsignals (730), das eine Gate-Spannung des Transistors (211) repräsentiert;
    Ermitteln eines Werts einer Ausgangsspannung (740) basierend auf dem ersten Messsignal und dem zweiten Messsignal; und
    Ermitteln einer zu bestimmenden Konzentration eines vorbestimmten Stoffes (750), die zu der Ausgangsspannung korrespondiert.

14. Verwenden einer aktiven Messschaltung (100) gemäß einem der Ansprüche 1 bis 12 oder eines Verfahrens (700) gemäß Anspruch 13 zum Ermitteln einer Stoff-Konzentration.

15. Verwenden einer aktiven Messschaltung (100) gemäß einem der Ansprüche 1 bis 12 oder eines Verfahrens (700) gemäß Anspruch 13 zum Messen eines Vorhandenseins und/oder einer Menge eines Biomarkers in vivo.

# FIG. 1A

211-i

Referenzelektrode

211-re

Lösung — 211-l

$U_{GS}$

211-ion

Ionensensitive Schicht

211-iso

Isolierende Schicht

211-s

211-d

Source

$n^+$

Kanal

Drain

$n^+$

$I_D$

Substrat

211-su

$U_{DS}$

# FIG 1B

100

10

$I_D$

110 — $U_{cc}$

230

OV

$U_{ref}$

211

Drain

FET

Source

—

14

$U_{bias}$

13

222

$U_{bias}$

$I_D$

FIG. 2A

EP 4 379 366 A1

# FIG. 2B

EP 4 379 366 A1

# FIG. 2C

**FIG. 2D**

290

$U_{Ref} = 0,026 \cdot U_{CC} + 216 \text{ mV}$

EP 4 379 366 A1

FIG. 3

EP 4 379 366 A1

FIG. 4

24

EP 4 379 366 A1

FIG. 5

FIG. 6

EP 4 379 366 A1

# FIG. 7

In-Kontakt bringen eines zu Untersuchenden Mediums mit dem Feldeffekttransistor der Biomarkersensoranordung ⟶ 710

Erfassen eines ersten Messsignals ⟶ 720

Erfassen eines zweiten Messsignals ⟶ 730

Ermitteln eines Werts einer Ausgangsspannung basierend auf dem ersten Messsignal und dem zweiten Messsignal, ⟶ 740

Ermitteln einer zu bestimmenden Konzentration ⟶ 750

Europäisches Patentamt
European Patent Office
Office européen des brevets

**EUROPÄISCHER RECHERCHENBERICHT**

Nummer der Anmeldung

EP 23 21 3212

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP 2016 194462 A (HITACHI AUTOMOTIVE SYSTEMS LTD) 17. November 2016 (2016-11-17) | 1-5,7-9, 12-14 | INV. G01N27/414 G01R31/26 |
| Y | * Abbildungen 1-7 * | 6,11 | |
| A | * Absatz [0007] – Absatz [0025] * ----- | 10 | |
| X | CN 103 399 071 B (UNIV SHANDONG NORMAL) 25. März 2015 (2015-03-25) | 1-5,9, 12,13,15 | |
| Y | * Abbildungen 1-5 * | 6,11 | |
| A | * Absatz [0009] – Absatz [0073] * ----- | 10 | |
| Y | EP 1 153 286 B1 (ENDRESS & HAUSERCONDUCTA GES F [DE]) 9. Februar 2005 (2005-02-09) * das ganze Dokument * ----- | 11 | |
| Y | DE 10 90 002 B (MINE SAFETY APPLIANCES CO) 29. September 1960 (1960-09-29) * das ganze Dokument * ----- | 6 | |

RECHERCHIERTE SACHGEBIETE (IPC)

G01N
G01R

Der vorliegende Recherchenbericht wurde für alle Patentansprüche erstellt

| Recherchenort | Abschlußdatum der Recherche | Prüfer |
|---|---|---|
| München | 16. April 2024 | Colasanti, Katharina |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 21 3212

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-04-2024

| Im Recherchenbericht angeführtes Patentdokument | Datum der Veröffentlichung | Mitglied(er) der Patentfamilie | | Datum der Veröffentlichung |
|---|---|---|---|---|
| JP 2016194462 A | 17-11-2016 | JP | 6506592 B2 | 24-04-2019 |
| | | JP | 2016194462 A | 17-11-2016 |
| CN 103399071 B | 25-03-2015 | KEINE | | |
| EP 1153286 B1 | 09-02-2005 | AT | E289064 T1 | 15-02-2005 |
| | | CA | 2354424 A1 | 22-06-2000 |
| | | DE | 19857953 A1 | 06-07-2000 |
| | | EP | 1153286 A1 | 14-11-2001 |
| | | JP | 2002532716 A | 02-10-2002 |
| | | US | 6624637 B1 | 23-09-2003 |
| | | WO | 0036408 A1 | 22-06-2000 |
| DE 1090002 B | 29-09-1960 | DE | 1090002 B | 29-09-1960 |
| | | FR | 1213120 A | 29-03-1960 |
| | | GB | 909413 A | 31-10-1962 |
| | | US | 2965842 A | 20-12-1960 |

EPO FORM P0461

Für nähere Einzelheiten zu diesem Anhang : siehe Amtsblatt des Europäischen Patentamts, Nr.12/82